# EUROPEAN PATENT APPLICATION

(11) **EP 1 894 628 A2**
(43) Date of publication of application: **05.03.2008**
(21) Application number: 07016869.5
(22) Date of filing: 28.08.2007
(51) Int. Cl.: B01J 35/00, B01J 35/10, B01J 31/12, B01J 31/16, B01J 31/18, B01J 31/20, B01J 31/22, B01J 31/24, C08G 77/04

(54) **Light energy conversion material comprising donor-acceptor substituted poylsiloxanes**

(30) Priority: 31.08.2006 JP 2006235099; 20.07.2007 JP 2007189545
(71) Applicant: KABUSHIKI KAISHA TOYOTA CHUO KENKYUSHO, Aichi-gun, Aichi-ken, 480-1192 (JP)
(72) Inventor: Inagaki, Shinji, Nagakute-cho Aichi-gun Aichi 480-1192 (JP); Aoki, Masao, 63517 Rodenbach (DE); Ohashi, Masataka, Nagakute-cho Aichi-gun Aichi 480-1192 (JP); Takeda, Hiroyuki, Nagakute-cho Aichi-gun Aichi 480-1192 (JP)
(74) Representative: Kramer - Barske - Schmidtchen

(57) **Abstract**

A light energy conversion material, comprising:
a polysiloxane porous material having a light-collecting antenna function; and
an electron donor and an electron acceptor disposed in at least one portion among a pore, a skeleton and the outer circumference of the porous material.

## Description

### BACKGROUND OF THE INVENTION

### Field of the Invention

The present invention relates to a light energy conversion material.

### Related Background Art

Studies on a light energy conversion material have so far been made. The light energy conversion material utilizes a photo-excited electron transfer reaction in which an electron is transferred from an electron donor to an electron acceptor in accordance with the absorption of light energy.

For example, Japanese Unexamined Patent Application Publication No. 2002-110260 (JP 2002-110260 A) discloses a light energy conversion material including a photoactive pigment, an electron donor, an electron acceptor, and a porous material having a pore with a pore wall thickness of 2 nm or less. The photoactive pigment is disposed inside or outside the pore. At least one of the electron donor and the electron acceptor is disposed inside the pore. Additionally, the electron donor and the electron acceptor are not disposed directly adjacent to each other, but are separated by the pore wall.

However, in the conventional light energy conversion material as described in JP 2002-110260 A, it is necessary to introduce a large amount of the photoactive pigment in the pore space to achieve a sufficiently large effect of collecting light. On the other hand, the electron donor or the electron acceptor is disposed in the pore space. Accordingly, it is spatially difficult to introduce a sufficiently large amount of the photoactive pigment in the pores. Consequently, the introduced amount of the photoactive pigment is not always sufficient. Even if the pore space is filled with the sufficient amount of the photoactive substance and the electronic substance in such a light energy conversion material, a chemical energy conversion reaction is not always sufficiently advanced using the pore space as a reaction field. Thus, the energy conversion efficiency is not always sufficient.

On the other hand, with respect to a thin film in which luminescent molecules are introduced, a method of making a mesostructured inorganic silicate thin film in which a pair of luminescent molecules such as a ruthenium complex and pyrene are introduced in the spatially separated region is disclosed (refer to "Placement and Characterization of Pairs of Luminescent Molecules in Spatially Separated Regions of Nanostructured Thin Films" in J. AM. CHEM. SOC., 2002, 124, 14388-14396). With respect to a luminescent material, a silica porous material containing a specific organic group showing fluorescence or phosphorescence is disclosed in International Publication No. WO2005/097944. However, it is not suggested to employ such a luminescent material and the like in the light energy conversion material.

### SUMMARY OF THE INVENTION

The present invention is made in consideration of the problems of the prior art. An object of the present invention is to provide a light energy conversion material which can advance a light energy conversion reaction with a high efficiency, resulting in the significant improvement in the light energy conversion efficiency, and, further, which can improve the physical stabilities of an electron donor and an electron acceptor to give the light conversion material a sufficient durability.

The present inventors have devoted themselves to keen studies so as to achieve the above object. As a result, the present inventors have discovered the following facts, and then completed the present invention. A light energy conversion material is obtained by using a porous material having a light-collecting antenna function, and the electron donor and the electron acceptor are disposed in at least one portion among a pore, a skeleton and the outer circumference of the porous material. The light energy conversion material can surprisingly advance a light energy conversion reaction with a high efficiency, resulting in the significant improvement in the light energy conversion efficiency, and further can improve the physical stabilities of the electron donor and the electron acceptor to give the light conversion material a sufficient durability.

In other words, the light energy conversion material of the present invention is a light energy conversion material comprising: a porous material having a light-collecting antenna function; and an electron donor and an electron acceptor disposed in at least one portion among a pore, a skeleton and the outer circumference of the porous material.

The porous material according to the present invention is preferably a silica porous material containing an organic group. Such an organic group preferably includes an organic molecule having an absorption band between 200 nm and 800 nm. Particular preferably are benzene, biphenyl, terphenyl, quaterphenyl, naphthalene, anthracene, naphthacene, rubrene, fluorene, carbazole, acridine, acridone, azulene, chrysene, pyrene, perylene, hexabenzocoronene, thiophene, oligothiophene, pyridine, oligopyridine, quinacridone, oligophenylenevinylene and oligophenylene ethynylene.

The porous material according to the present invention preferably has a periodic structure with an interval of 5 nm or less based on the regular arrangement of the organic group.

The porous material according to the present invention preferably has the pore with a central pore diameter of 1 nm to 30 nm.

Furthermore, the porous material according to the present invention more preferably has one or more peaks at a diffraction angle corresponding to a d value of 1 nm or more in an X-ray diffraction pattern.

The electron donor according to the present invention is preferably at least one kind selected from the group consisting of an aromatic compound, a peri-condensed aromatic compound, a polycyclic aromatic compound, a nitrogen-containing aromatic compound, a sulfur-containing aromatic compound, an aromatic vinyl polymer, an aromatic amine compound, an alkyl amine compound, a nitro compound, a metal complex having a nitrogen-containing organic ligand, a metal complex having a cyclic ligand, a metal complex salt, a metal ion, a rare-earth ion, a halogen ion, and a derivative thereof. Above all, particularly preferable is at least one kind selected from the group consisting of naphthol, carbazole, 1,4-diazabicyclo[2,2,2]octane, Cr(CN)₆³⁻, Eu²⁺, Fe(CN)₆⁴⁻, Fe²⁺, Mg(phthalocyanine)⁴⁺, phenylenediamine, N,N,N',N'-tetramethylbenzidine, N,N-diethylaniline, N,N-dimethylaniline, Pt₂(P₂O₅)₄H₈⁴⁻, ReCl₈²⁻, Rh₂(1,3-diisocyanopropane)₄²⁺, Ru(bipyridine)₃²⁺, Tetrakis(dimethylamino)ethylene (TDAE), a Zn porphyrin complex, a Zn phthalocyanine complex, anthracene, indene, oxadiazole, oxazole, quadricyclane, diazabicyclooctane, diphenylethylene, triethylamine, triphenylmethane, trimethoxybenzene, naphthalene, norbornadiene, hydrazone, pyrene, phenanthrene, phenothiazine, perylene, and a derivative thereof.

The electron acceptor according to the present invention is preferably at least one kind selected from the group consisting of a quinone compound, an aromatic compound having a vinyl group, an aromatic compound having a cyano group, an aromatic compound having a nitro group, a nitrogen-containing aromatic compound, an organic compound having a dicyanomethylene group, a molecular metal complex containing an organic compound having a dicyanomethylene group as a ligand, an organic compound having a cyanoimino group, a molecular metal complex containing an organic compound having a cyanoimino group as a ligand, fullerene, a carbon nanotube, a metal complex having a nitrogen-containing organic ligand, a metal complex having a cyclic ligand, a metal complex salt, a metal ion, a metal oxide, and a derivative thereof. Above all, particularly preferable are at least one kind selected from the group consisting of a Cr (bipyridine) complex, Cr(CN)₆³⁻, Fe(CN)₆⁴⁻, Fe³⁺, N,N-dimethylaniline, Pt₂(P₂O₅)₄H₈⁴⁻, methyl cyanobenzoate, dicyanobenzene, dinitrobenzene, benzoquinone, ReCl₈²⁻, Rh₂(1,3-diisocyanopropane)₄²⁺, a Ru(bipyridine)complex, stilbene, UO₂²⁺, a Zn porphyrin complex, Zn phthalocyanine, acetophenone, anthracene, an osmium (II) complex, chloranil, cyanoanthracene, cyanonaphthalene, dimethylaniline, dicyanoanthracene, dicyanonaphthalene, dimethylbicyclohepta-2,5-diene-2,3-dicarboxylate, tetracyanoanthracene, tetracyanoethylene, triphenylpyrylium tetrafluoroborate, naphthalene, nitrobenzene, viologen, phenanthrene, fullerene C60, fullerene C60-µ-oxodimer(C1200), fullerene C70, benzophenone, methylviologen, methoxyacetophenone, oxygen, and a derivative thereof.

Note that, the reasons why the above object is achieved by use of the light energy conversion material of the present invention are not necessarily defined, but the present inventors estimate the reasons as follows. Specifically, the porous material having a light-collecting antenna function is used in the present invention. When irradiated with light, the porous material can absorb the light energy, and can collect the excited energy in a particular portion. Accordingly, the porous material itself efficiently absorbs light, and significantly improves the efficiency of absorbing light energy as compared to that of the conventional light energy conversion material. The energy excited by irradiating the light is introduced from the porous material (energy donor) to the electron donor (energy acceptor). In the present invention, the above light-collecting antenna function allows the excited energy to be transferred to the electron donor with a high efficiency. Such a transfer of the excited energy occurs not only between the porous material (energy donor) and the electron donor (energy acceptor), but also occurs in the skeleton of the porous material itself. Thus, it is possible to inject the excited energy efficiently into the electron donor disposed in the porous material. Additionally, such a transfer efficiency of the excited energy in the skeleton depends on the structure of the porous material. Therefore, the use of the porous material having a more regularly arranged structure allows the energy to be more efficiently transferred. In addition, in the present invention, the porous material significantly improves the efficiency of absorbing light, and also the electron donor offers a photosensitization effect. Accordingly, the introduction of the electron donor and the electron acceptor in the porous material accelerates the occurrence of electrons and holes by the charge separation between the electron donor and the electron acceptor. As a result, the light energy conversion efficiency is significantly improved. Moreover, the distance between the electron donor and the electron acceptor can be made small by fixing them in the narrow pore, the skeleton, and the like of the porous material. As a result, the charge separation can also be accelerated. Furthermore, the electron donor and the electron acceptor are physically stabilized by fixing them in the pore, the skeleton, and the like, of the porous material. As a result, the durability of the light conversion material is improved. Still furthermore, the porous material can also selectively absorb the light such as ultraviolet light having a strong energy. Thus, the electron donor and the like are inhibited from being deteriorated due to the light such as ultraviolet light having a strong energy, resulting in the improvement in the durability.

The present invention makes it possible to provide a light energy conversion material which can advance a light energy conversion reaction with a high efficiency, resulting in the significant improvement in the light energy conversion efficiency, and, further, which can improve the physical stabilities of an electron donor and an electron acceptor to give the light conversion material a sufficient durability.

### BRIEF DESCRIPTION OF THE DRAWINGS

Fig. 1 is a graph showing an XRD diffraction pattern of BiPh-HMM obtained in Synthesis example 1.
Fig. 2 is a graph showing a nitrogen adsorption and desorption isotherm of the BiPh-HMM obtained in Synthesis example 1.
Fig. 3 is a graph showing XRD diffraction patterns of light energy conversion materials obtained in Example 2 and Comparative example 1.
Fig. 4 is a graph showing nitrogen adsorption and desorption isotherms of the light energy conversion materials obtained in Examples 1 and 2 and Comparative example 1.
Fig. 5 is a graph showing UV/Vis spectra (diffuse reflection spectra) of the light energy conversion materials obtained in Examples 1 and 2 and Comparative example 1.
Fig. 6 is a graph showing luminescence spectra obtained when the BiPh-HMM obtained in Synthesis example 1 and the light energy conversion materials obtained in Examples 1 and 2 and Comparative example 1 are excited with the light having a wavelength of 260 nm.
Fig. 7 is a graph showing luminescence spectra within a wavelength range of 500 nm to 700 nm obtained when the BiPh-HMM obtained in Synthesis example 1 and the light energy conversion materials obtained in Examples 1 and 2 and Comparative example 1 are excited with the light having a wavelength of 260 nm.
Fig. 8 is a graph showing excitation spectra obtained when the BiPh-HMM obtained in Synthesis example 1 and the light energy conversion materials obtained in Examples 1 and 2 and Comparative example 1 are measured at 380 nm.
Fig. 9 is a graph showing excitation spectra obtained when the BiPh-HMM obtained in Synthesis example 1 and the light energy conversion materials obtained in Examples 1 and 2 and Comparative example 1 are measured at 600 nm.
Fig. 10 is a graph showing an excitation spectrum obtained when Ru(dmb)₂BiPy'-FSM obtained in Comparative example 1 is measured at 600 nm, and a UV/Vis spectrum of Ru(dmb)₃(PF₆)₂ in an acetonitrile solution.
Fig. 11 is a graph showing a luminescence spectrum obtained when Ru(dmb)₃SH-BiPh-HMM obtained in Synthesis example 5 is excited with the light having a wavelength of 260 nm.
Fig. 12 is a graph showing a luminescence spectrum within a wavelength range of 500 nm to 700 nm obtained by performing measurement with a high sensitivity while removing the light having a wavelength of 420 nm or less, when the Ru(dmb)₃SH-BiPh-HMM obtained in Synthesis example 5 is excited with the light having a wavelength of 260 nm.
Fig. 13 is a graph showing an excitation spectrum obtained when the Ru(dmb)₃SH-BiPh-HMM obtained in Synthesis example 5 is measured at 380 nm.
Fig. 14 is a graph showing an excitation spectrum obtained when the Ru(dmb)₃SH-BiPh-HMM obtained in Synthesis example 5 is measured at 600 nm.
Fig. 15 is a graph showing an IR spectrum of ReCl(CO)₃BiPy'-BiPh-HMM obtained in Example 3.
Fig. 16 is a graph showing a UV/Vis spectrum (diffuse reflection spectrum) of the ReCl(CO)₃BiPy'-BiPh-HMM obtained in Example 3.

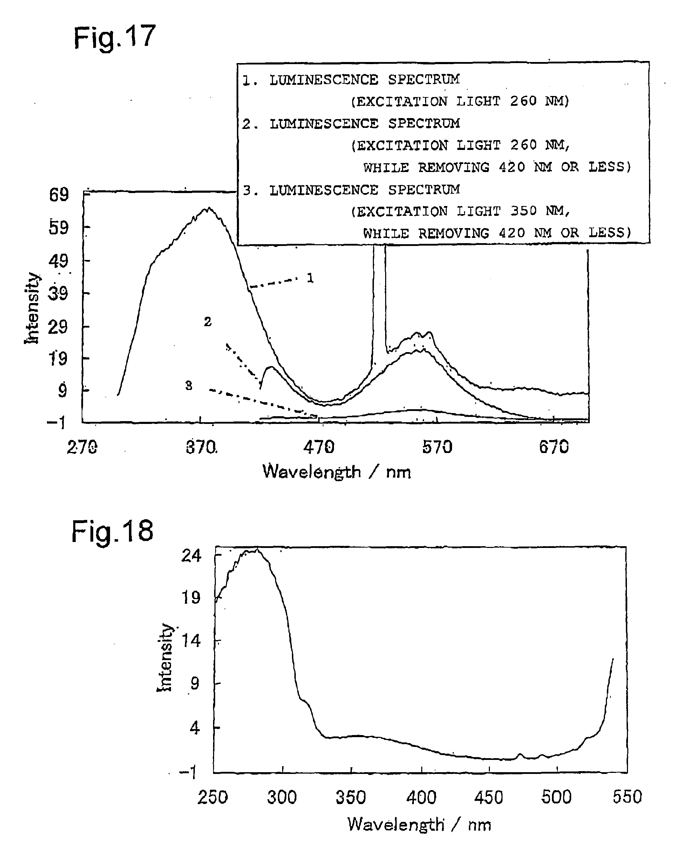

Fig. 17 is a graph showing: a luminescence spectrum obtained when the ReCl(CO)₃BiPy'-BiPh-HMM obtained in Example 3 is excited with the light having a wavelength of 260 nm; a luminescence spectrum obtained by performing measurement with a high sensitivity while removing the light having a wavelength of 420 nm or less when the ReCl(CO)₃BiPy'-BiPh-HMM is excited with the light having a wavelength of 260 nm; and a luminescence spectrum obtained by performing measurement with a high sensitivity while removing the light having a wavelength of 420 nm or less when the ReCl (CO)₃BiPy'-BiPh-HMM is excited with the light having a wavelength of 350 nm.
Fig. 18 is a graph showing an excitation spectrum obtained when the ReCl(CO)₃BiPy'-BiPh-HMM obtained in Example 3 is measured at 550 nm.
Fig. 19 is a graph showing UV/Vis spectrum (diffuse reflection spectrum) of each BiPh-HMM obtained in Examples 4 to 7 which both a rhenium complex and a ruthenium complex are fixed to.
Fig. 20 is a graph showing an IR spectrum of each BiPh-HMM obtained in Examples 4 to 7 which both the rhenium complex and the ruthenium complex are fixed to.
Fig. 21 is a graph showing the relationship between the generated amount of carbon monoxide and the light irradiation time for BiPh-HMM obtained in Example 4 which both the rhenium complex and the ruthenium complex are fixed to.
Fig. 22 is a graph showing XRD diffraction patterns of each BiPy'-BiPh-HMM obtained in Synthesis examples 6 to 9.
Fig. 23 is a graph showing nitrogen adsorption isotherms of each BiPy'-BiPh-HMM obtained in Synthesis examples 6 to 9.
Fig. 24 is a graph showing the relationship between the generated amount of carbon monoxide and the light irradiation time on each light energy conversion material obtained Examples 3 and 14.

### DETAILED DESCRIPTION OF THE PREFERRED EMBODIMENTS

The present invention will hereinafter be described in detail according to the preferred embodiments.

A light energy conversion material of the present invention includes: a porous material having a light-collecting antenna function; and an electron donor and an electron acceptor disposed in at least one portion among a pore, a skeleton and the outer circumference of the porous material.

Firstly, the porous material according to the present invention will be described. For such a porous material, it is only necessary to have a light-collecting antenna function (function of absorbing light energy to be excited, and collecting the energy in a specific portion), and the porous material is not particularly limited. As the porous material, a silica porous material containing an organic group is preferable.

Such a silica porous material containing an organic group includes a silica porous material made of a polymer of organic silicon compounds represented by, for example, the following general formula (1):

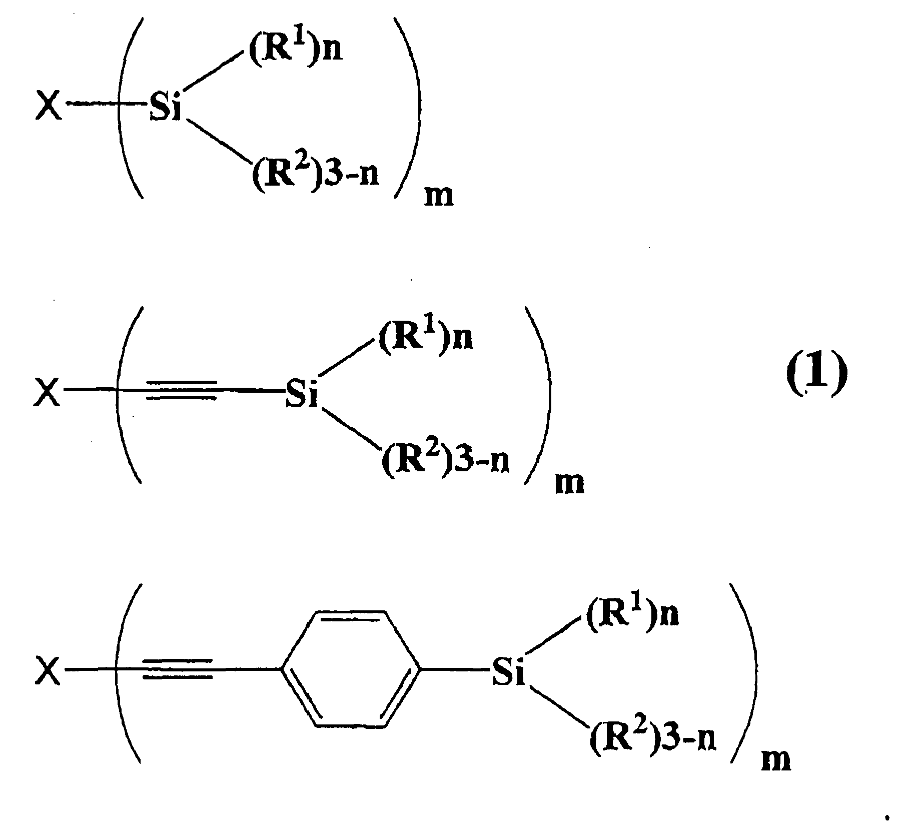

In the general formula (1), X is an organic group. The organic group included in such a silica porous material preferably has an energy difference of 36 kcal/mol to 144 kcal/mol between the singlet excited state or the triplet excited state and the ground state. When such an energy difference is less than the lower limit, an excitation light source having a wavelength of 200 nm or less is needed. Accordingly, such a silica porous material tends to be utilized with difficulty as a light energy conversion material. In contrast, when the energy difference is more than the upper limit, an excitation light source having a wavelength of 800 nm or more is needed. Accordingly, such a silica porous material tends to be utilized with difficulty.

Furthermore, the organic group is preferably made of an organic molecule having an absorption band between 200 nm and 800 nm from the point of view that the light-collecting antenna function should be exerted with a higher efficiency. For this reason, examples of such an organic group include: an organic group made of fluorene which may have a substituent group represented by the following general formula (2): 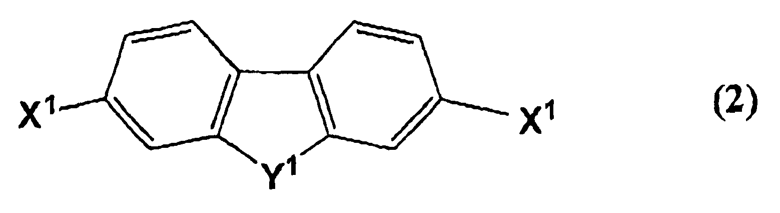 [where Y¹< is any one selected from the group consisting of the substituent groups represented by the following general formula (3): 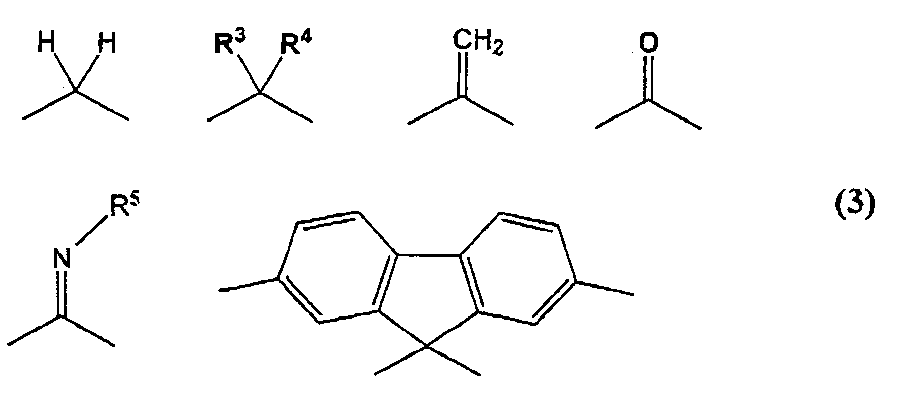 (where R³ and R⁴ may be the same or different, and are independently a hydrogen atom, a hydroxyl group, a phenyl group, an alkyl group having a carbon number of 1 to 22 or a perfluoroalkyl group having a carbon number of 1 to 22, and where R⁵ is a hydrogen atom, an alkyl group having a carbon number of 1 to 22, a perfluoroalkyl group having a carbon number of 1 to 22 or an aryl group having a carbon number of 6 to 8)];
an organic group made of pyrene represented by the following general formula (4): 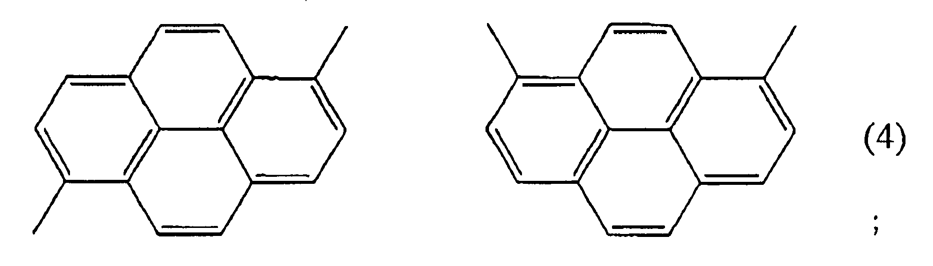 an organic group made of acridine which may have a substituent group represented by the following general formula (5): 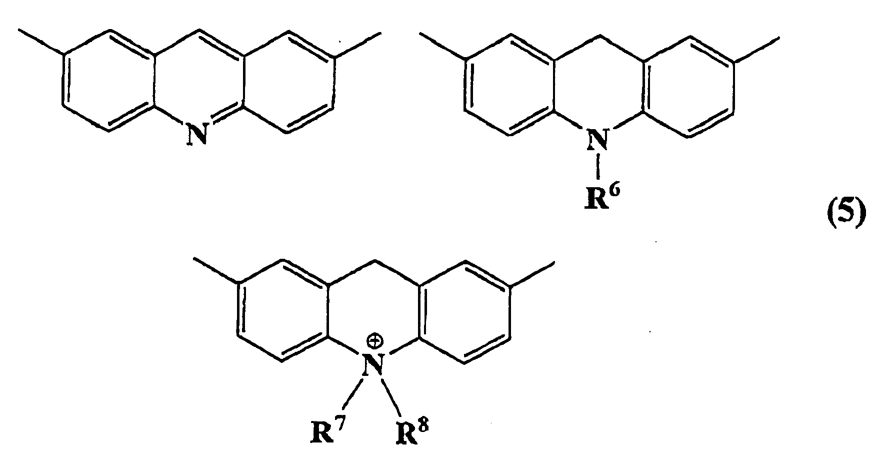 (where R⁶ is a hydrogen atom, an alkyl group having a carbon number of 1 to 22, a perfluoroalkyl group having a carbon number of 1 to 22 or an aryl group having a carbon number of 6 to 8, and where R⁷ and R⁸ may be the same or different, and are independently a hydrogen atom, a hydroxyl group, a phenyl group, an alkyl group having a carbon number of 1 to 22 or a perfluoroalkyl group having a carbon number of 1 to 22);
an organic group made of acridone represented by the following general formula (6): 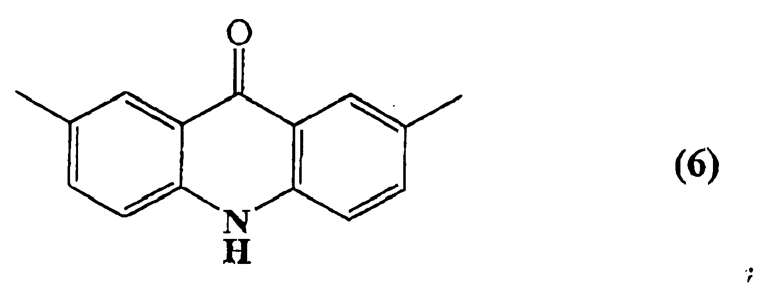 an organic group made of quaterphenyldisilane represented by the following general formula (7): 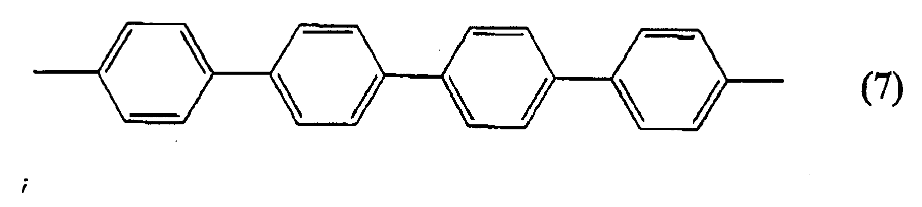 an organic group made of anthracene which may have a substituent group represented by the following general formula (8): 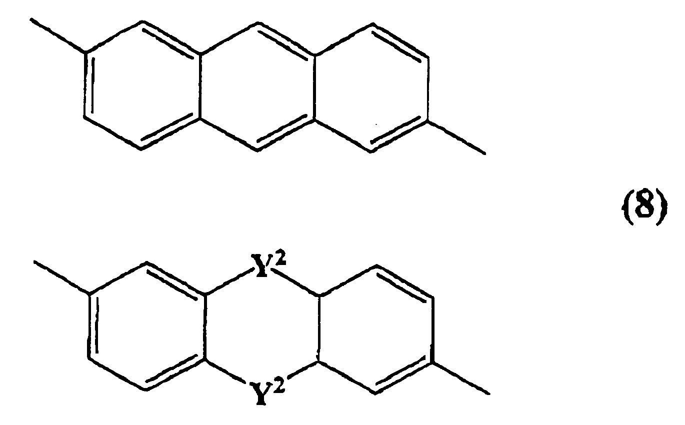 [where Y²< is a substituent group represented by the following general formula (9): 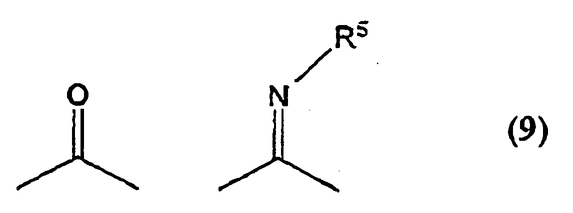 (where R⁵ is a hydrogen atom, an alkyl group having a carbon number of 1 to 22, a perfluoroalkyl group having a carbon number of 1 to 22 or an aryl group having a carbon number of 6 to 8)].

In the general formula (1), R¹ is at least one selected from the group consisting of a lower alkoxy group {preferably an alkoxy group (RO-) having a carbon number of 1 to 5}, a hydroxyl group (-OH), an allyl group (CH₂=CH-CH₂-), an ester group (preferably an ester group (RCOO-) having a carbon number of 1 to 5}, and a halogen atom (chlorine atom, fluorine atom, bromine atom, iodine atom). In particular, the lower alkoxy group and/or the hydroxyl group are preferable from the point of view that the condensation reaction is easily controlled. Incidentally, when a number of R¹s are present in the same molecule, R¹s may be either the same or different.

Moreover, in the general formula (1), R² is at least one selected from the group consisting of a lower alkyl group (preferably an alkyl group (R-) having a carbon number of 1 to 5} and a hydrogen atom. Incidentally, when a number of R²s are present in the same molecule, R²s may be the same or different.

Furthermore, n and (3-n) in the general formula (1) are respectively the number of R¹ and R² bound to silicon atom (Si). Such n is an integer of 1 to 3, and is particularly preferably 3 from the point of view that the structure formed after condensation is stable. m in the general formula (1) is the number of the silicon atom (Si) bound to the organic group (X). Such m is an integer of 1 to 4, and is particularly preferably 2 from the point of view that a stable siloxane network is easily formed.

The porous material formed by polymerizing the organic silicon compounds represented by the general formula (1) may be formed either by polymerizing one kind of a monomer of the organic silicon compounds represented by the general formula (1) or by copolymerizing two or more kinds of the monomers. In addition, such a porous material may be formed (i) by copolymerizing the organic silicon compound represented by the general formula (1) and an organic silicon compound with other organic group than the above-described organic groups in place of X in the general formula (1), or (ii) by copolymerizing the organic silicon compound represented by the general formula (1) and the other monomer. The organic silicon compound represented by the general formula (1) and the monomer supplied for the copolymerization as necessary are hereinafter collectively named "monomer".

Such other organic group includes an organic group having a valence of one or more formed by removing one or more hydrogen atoms from a hydrocarbon such as alkane, alkene, alkyne, and cycloalkane, but is not limited to these. The other organic group may also have an amide group, an amino group, an imino group, a mercapto group, sulfone group, a carboxyl group, an ether group, an acyl group, a vinyl group, and the like. The monomer other than the organic silicon compounds represented by the general formula (1) includes silicon compounds such as alkoxysilane and alkylalkoxysilane, and moreover may be a metal compound including an inorganic component such as aluminium, titanium, magnesium, zirconium, tantalum, niobium, molybdenum, cobalt, nickel, gallium, beryllium, yttrium, lanthanum, hafnium, tin, lead, vanadium and boron. Note that, in a case of the copolymerization of the (i) or (ii), the ratio of the organic silicon compound represented by the general formula (1) preferably accounts for 30% or more in the total amount of the monomer to be copolymerized.

When the organic silicon compounds represented by the general formula (1) are polymerized, a siloxane binding (Si-O-Si) is formed through the hydrolysis and the subsequent condensation reaction in the portion where R¹ is bound to Si in the general formula (1). At this time, a silanol group (Si-OH) is formed in part. Even if the silanol group is formed, the characteristics of the porous material are not affected. For example, when the polymerization reaction is performed on the organic silicon compounds in which R¹ is an ethoxy group, n is 3, and m is 2 in the general formula (1), the reaction equation is represented by the following general formula (10): 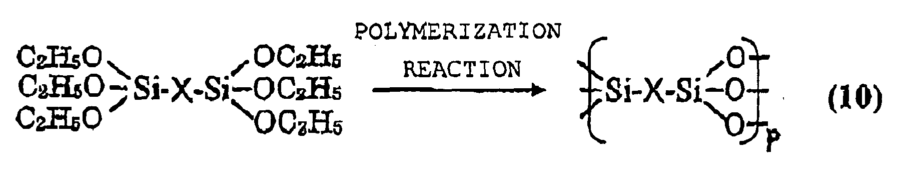 [where X is the above organic group, p is an integer corresponding to the number of polymerization repetition.]
Incidentally, the number of p is not particularly limited, and is preferably within a range of about 10 to 1000 in general.

The polymer formed by polymerizing the monomers in the above manner is an organic silica-base material having a skeleton with an organic group (X), silicon atoms (Si) and oxygen atoms (O) as main components. The polymer has a highly cross-linked network structure with a basic skeleton (-X-Si-O-) in which the silicon atoms is bound to the organic group with the oxygen atoms bound to the silicon atom.

A method of polymerizing the monomers is not particularly limited. The polymerization method is preferably performed by hydrolyzing and condensing the monomers in the presence of an acidic or basic catalyst using water or a mixture solvent of water and an organic solvent as a solvent. The organic solvent suitably used here includes alcohol, acetone, and the like. When the mixture solvent is used, the content of the organic solvent is preferably about 5% by weight to 50% by weight. The acidic catalyst to be used includes a mineral acid such as hydrochloric acid, nitric acid, sulfuric acid, and the like. When the acidic catalyst is used, the solution is preferably acid with a pH of 6 or less (more preferably 2 to 5). In addition, the basic catalyst to be used includes sodium hydroxide, ammonium hydroxide, potassium hydroxide, and the like. When the basic catalyst is used, the solution is preferably basic with a pH of 8 or more (more preferably 9 to 11).

The content of the monomers in the polymerization process is preferably about 0.0055 mol/L to 0.33 mol/L in the concentration of silicon equivalent. The various conditions (temperature, time, and the like) in the polymerization process are not particularly limited, and suitably selected in accordance with the targeted polymer and the monomer to be used. In general, the organic silicon compound is preferably hydrolyzed and condensed at a temperature of about 0°C to 100°C for a time period of about 1 hour to 48 hours.

The polymer formed by polymerizing the monomers (polymer of the organic silicon compounds represented by the general formula (1)) generally has an amorphous structure, but can have a periodic structure based on a regular arrangement of the organic groups, depending on the synthesis conditions. Although such periodicity depends on the molecular length of the monomers to be used, the periodicity of the periodic structure is preferably 5 nm or less. The periodic structure is maintained even after the monomers are polymerized. The formation of the periodic structure can be recognized by the peak appeared in a region where the d value is 5 nm or less in the X-ray diffraction (XRD) measurement. Even when such a peak is not recognized in the X-ray diffraction measurement, the periodic structure is partially formed in some cases. Such a periodic structure is generally formed with a layered structure described below, but not limited to this case.

When the periodic structure is formed in the porous material according to the present invention on the basis of the regular arrangement of the organic group, the energy transfer efficiency tends to be significantly improved. The mechanism in which the formation of the periodic structure significantly improves the energy transfer efficiency as described above is not necessarily defined. However, the present inventors estimate the mechanism as follows. Specifically, when the organic groups are regularly arranged as described above, a uniform band structure is formed and maintained. As a result, the energy excited by efficient light absorption can efficiently be transferred within the regularly arranged organic groups. The energy transfer efficiency therefore is significantly improved when the organic groups are regularly arranged in the above manner.

The synthesis conditions suitable for forming such a periodic structure based on the regular arrangement of the organic groups include the following various conditions.
(i) The periodic structure is formed by the interaction exerted within the monomers. Thus, it is preferable to use the organic group (X) which increases the interaction within the monomers, i.e. benzene, biphenyl, naphthalene and anthracene.
(ii) The solution preferably has a pH of 1 to 3 (acidic) or 10 to 12 (basic), and more preferably has 10 to 12 (basic).

Such a periodic structure can be obtained according to the method described in, for example, S. Inagaki et al., Nature, 2002, vol. 416, pp 304-307.

Furthermore, pores can be formed in the obtained polymer (polymer of the organic silicon compounds represented by the general formula (1)) by controlling the synthesis conditions when the monomers are polymerized, or by mixing a surfactant with the raw materials. In the former case, the solvent serves as a mold. In the latter case, the micelle or a liquid crystal structure in the surfactant serves as a mold. Accordingly, the porous material having pores is formed.

In particular, the surfactant to be described below is preferably used because a mesoporous material having a mesopore with a central pore diameter of 1 nm to 30 nm in a pore diameter distribution curve is obtained. The central pore diameter is a pore diameter at the maximum peak of the curve (pore diameter distribution curve) obtained by plotting values (dV/dD) obtained by differentiating the pore volume (V) by the pore diameter (D) to the pore diameter (D). The central pore diameter can be obtained by the method described below. Specifically, the porous material is cooled to a liquid nitrogen temperature (-196°C). Then, a nitrogen gas is introduced to determine the absorbed amount thereof by a volumetrical method or gravimetrical method. Thereafter, the pressure of the nitrogen gas to be introduced is gradually increased. Then, the adsorbed amount of the nitrogen gas to each equilibrium pressure is plotted to obtain an adsorption isotherm. Using the adsorption isotherm, a pore diameter distribution curve can be obtained by a Cranston-Inklay method, Pollimore-Heal method or BJH method.

Such a mesoporous material preferably has the pore with a central pore diameter of 1 nm to 30 nm. When the central pore diameter is less than the lower limit, the size of average of pore tend to become small compared with the size of the electron donor and the electron acceptor. In contrast, when the central pore diameter exceeds the upper limit, the photocatalytic performance tends to reduce.

Such a mesoporous material preferably has 60% or more of the total pore volume within a range of ±40% of the central pore diameter in the pore diameter distribution curve. The fact that the mesoporous material satisfies this condition means that the mesoporous material has pores with very uniform diameters. The specific surface area of the mesoporous material is not particularly limited, and is preferably 700 m²/g or more. The specific surface area can be calculated as a BET specific surface area from the adsorption isotherm by using a BET isothermal adsorption equation.

Furthermore, such a mesoporous material preferably has one or more peaks at a diffraction angle corresponding to the d value of 1 nm or more (more preferably 1.5 nm to 30.5 nm) in the X-ray diffraction (XRD) pattern. The X-ray diffraction peak means that the periodic structure having the d value corresponding to the peak angle is present in the sample. Accordingly, the fact that one or more peaks are present at a diffraction angle corresponding to the d value of 1.5 nm to 30.5 nm means that the pores are regularly arranged at intervals of 1.5 nm to 30.5 nm.

The pores which such a mesoporous material includes are formed not only on the surface of the porous material but also in the inside thereof. The pore arrangement state (pore arrangement structure or structure) in such a porous material is not particularly limited, and is preferably of a 2d-hexagonal structure, 3d-hexagonal structure, or a cubic structure. Such a pore arrangement structure may have a disordered pore arrangement structure.

Here, the fact that the porous material has a hexagonal pore arrangement structure means that the arrangement of the pores is of a hexagonal structure (see: S. Inagaki et. al., J. Chem. Soc., Chem. Commun., p.680 (1993); S. Inagaki et al., Bull. Chem. Soc. Jpn., 69, p.1449 (1996); Q. Huo et al., Science, 268, p.1324 (1995)). Moreover, the fact that the porous material has a cubic pore arrangement structure means that the arrangement of the pores is of a cubic structure (see: J. C. Vartuli et al., Chem. Mater., 6, p.2317 (1994); Q. Huo et al., Nature, 368, p. 317 (1994)). In addition, the fact that the porous material has a disordered pore arrangement structure means that the arrangement of the pores is irregular (see: P. T. Tanev et al., Science, 267, p.865 (1995); S. A. Bagshaw et al., Science, 269, p.1242 (1995); R. Ryoo et al., J. Phys. Chem., 100, p.17718 (1996)). Furthermore, the cubic structure is preferably Pm-3n, Ta-3d, Im-3m or Fm-3m symmetrical. The symmetrical property is determined based on the notation of a space group.

When the above mentioned periodic structure is formed in the pore wall of such a porous material, the energy transfer from the organic group of the porous material to the electron donor is efficiently occurred. Furthermore, a surfactant is desirably added to the monomers for polymerization to obtain the mesoporous material. This is because the added surfactant serves as a mold in the polycondensation of the monomers to form the mesopores.

Such a surfactant used in obtaining the mesoporous material is not particularly limited, and may be any one of cationic, anionic and non-ionic. To be more specific, the surfactant includes: the chloride, bromide, iodide and hydroxide of alkyltrimethylammonium, alkyltriethylammonium, dialkyldimethylammonium, benzyl ammonium and the like; fatty acid salt, alkylsulfonate, alkylphosphate, polyethyleneoxide-based non-ionic surfactant, primary alkyl amine and the like. These surfactants are used alone or in mixture of two or more kinds.

Of the surfactants, the polyethyleneoxide-based non-ionic surfactant includes one having a hydrocarbon group as a hydrophobic component, and polyethylene oxide as a hydrophilic component. The surfactant preferably can be used is one represented by a general formula, for example, CₙH₂ₙ₊₁(OCH₂CH₂)ₘOH where n is 10 to 30 and where m is 1 to 30. Additionally, the esters of sorbitan and fatty acids such as oleic acid lauric acid, stearic acid, palmitic acid and the like, as well as the compounds formed by adding polyethylene oxide to these esters can also be used as the surfactant.

Furthermore, the triblock copolymer of polyalkylene oxide can be used as the surfactant. Such a surfactant includes one which is made of polyethylene oxide (EO) and polypropylene oxide (PO), and which is represented by a general formula (EO)ₓ(PO)_{y}(EO)ₓ. Here, x and y represent the repetition numbers of EO and PO, respectively. Preferably, x is 5 to 110, and y is 15 to 70. More preferably, x is 13 to 106, and y is 29 to 70. The triblock copolymer includes (EO)₁₉(PO)₂₉(EO)₁₉, (EO)₁₃(PO)₇₀(EO)₁₃, (EO)₅(PO)₇₀(EO)₅, (EO)₁₃(PO)₃₀(EO)₁₃, (EO)₂₀(PO)₃₀(EO)₂₀, (EO)₂₆(PO)₃₉(EO)₂₆, (EO)₁₇(PO)₅₆(EO)₁₇, (EO)₁₇(PO)₅₈(EO)₁₇, (EO)₂₀(PO)₇₀(EO)₂₀, (EO)₈₀(PO)₃₀(EO)₈₀, (EO)₁₀₆(PO)₇₀(EO)₁₀₆, (EO)₁₀₀(PO)₃₉(EO)₁₀₀, (EO)₁₉(PO)₃₃(EO)₁₉ and (EO)₂₆(PO)₃₆(EO)₂₆. These triblock copolymers are available from BASF Corp., Aldrich Corp., and the like. The triblock copolymer having desired x and y values can also be obtained in a small-scale production level.

A star diblock copolymer formed by binding two polyethylene oxide (EO) chain-polypropylene oxide (PO) chains to each of two nitrogen atoms of ethylenediamine can also be used. Such a star diblock copolymer includes one represented by a general formula ((EO)ₓ(PO)_{y})₂NCH₂CH₂N((PO)_{y}(EO)ₓ)₂ where x and y represent the repetition numbers of EO and PO, respectively. Preferably, x is 5 to 110, and y is 15 to 70. More preferably, x is 13 to 106, and y is 29 to 70.

Of such surfactants, the salt (preferably halide salt) of alkyltrimethylammonium [CₚH₂ₚ₊₁N(CH₃)₃] is preferably used because the mesoporous material having a high crystallinity can be obtained. In this case, alkyltrimethylammonium preferably has a carbon number of 8 to 22 in the alkyl group thereof. Such a substance includes octadecyltrimethylammonium chloride, hexadecyltrimethylammonium chloride, tetradecyltrimethylammonium chloride, dodecyltrimetylammonium bromide, decyltrimethylammonium bromide, octyltrimethylammonium bromide, docosyltrimethylammonium chloride and the like.

To obtain the mesoporous material as the polymer of the monomers, the monomers are polymerized in a solution containing the surfactant. The concentration of the surfactant in the solution is preferably 0.05 mol/L to 1 mol/L. When the concentration is less than the lower limit, the pores tend to incompletely be formed. In contrast, when the concentration exceeds the upper limit, the amount of the surfactant which is unreacted and left in the solution tends to be increased. As a result, the uniformity of the pores tends to be reduced.

A method of removing the surfactant contained in the thus obtained mesoporous material includes, for example, (i) a method of removing the surfactant by immersing the mesoporous material in an organic solvent (for example ethanol) with a high solubility to the surfactant, (ii) a method of removing the surfactant by calcining the mesoporous material at 300°C to 1000°C, and (iii) an ion-exchange method in which the mesoporous material is immersed in an acidic solution and heated to exchange the surfactant with hydrogen ions.

Such a mesoporous material can be obtained according to the method described in Japanese Unexamined Patent Application Publication No. 2001-114790 and the like.

Next, the electron donor and the electron acceptor according to the present invention will be described. In the present invention, the electron donor and the electron acceptor are disposed in at least one portion among the pore, the skeleton and the outer circumference of the porous material. The herein recited "disposition" is referred to the state in which the electron donor and the electron acceptor are fixed by covalent binding, ion-exchange, physical exchange, and the like in at least one portion among the pore, the skeleton and the outer circumference of the porous material. When the light energy conversion material of the present invention is irradiated with light, the excited energy is transferred from the porous material to the electron donor. The conditions under which the energy is transferred from the porous material (energy donor) to the electron donor (energy acceptor) are obtained by using the following equation (1) concerning the Foerster's energy transfer: 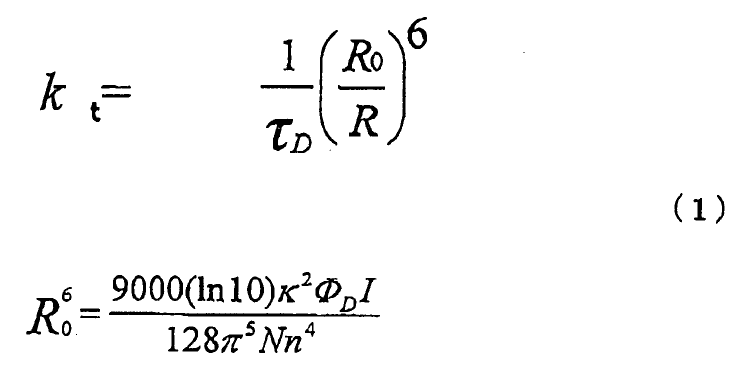 where kₜ represents the transfer rate of the excited energy, τ_{D} represents the fluorescence lifetime of the energy donor, R represents the distance between the energy donor and the energy acceptor, Rₒ represents a Foerster radius, K represents an orientation factor, Φ_{D} represents the fluorescence quantum yield of the energy donor, I represents the degree of the overlap of the luminescence spectrum of the energy donor and the absorption spectrum of the energy acceptor, N represents the Avogadro constant, and n represents the refraction index of the solvent. The conditions for preferred combinations of the porous material (energy donor) and the electron donor (energy acceptor) can also be obtained by using the equation (1). Specifically, it is recognized by using the equation (1) that the transfer rate of the energy is increased by larger degree of the overlap of the luminescence spectrum of the porous material and the absorption spectrum of the electron donor. Therefore, the preferred condition for the electron donor can be determined by determining the porous material.

Such an electron donor is not particularly limited, and the electron donor suitably used can be at least one kind selected from the group consisting of an aromatic compound, a peri-condensed aromatic compound, a polycyclic aromatic compound, a nitrogen-containing aromatic compound, a sulfur-containing aromatic compound, an aromatic vinyl polymer, an aromatic amine compound, an alkyl amine compound, a nitro compound, a metal complex having a nitrogen-containing organic ligand, a metal complex having a cyclic ligand, a metal complex salt, a metal ion, a rare-earth ion, a halogen ion, and a derivative thereof. Above all, more preferably used electron donors are compounds represented by the following general formula (11): 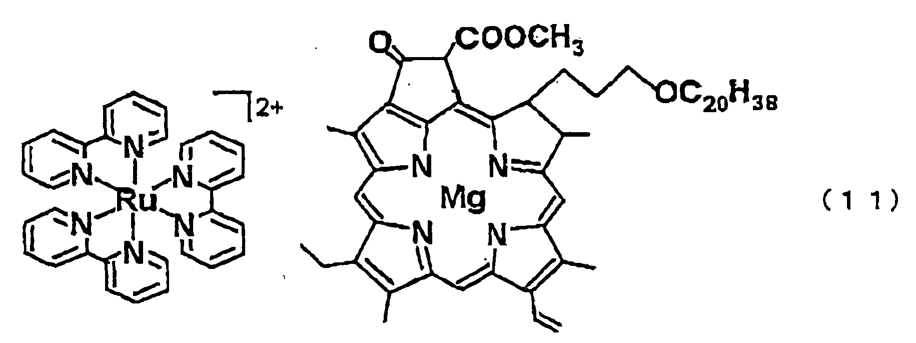 , naphthol, carbazole, 1,4-diazabicyclo[2,2,2]octane, Cr(CN)6³⁻, Eu²⁺, Fe(CN)₆¹⁻, Fe²⁺, Mg(phthalocyanine)⁴⁺, phenylenediamine, N,N,N',N'-tetramethylbenzidine, N,N-diethylaniline, N,N-dimethylaniline, Pt₂(P₂O₅)₄H₈⁴⁻, ReCl₈²⁻, Rh₂(1,3-diisocyanopropane)₄²⁺, Ru(bipyridine)₃²⁺, Tetrakis(dimethylamino)ethylene (TDAE), a Zn porphyrin complex, a Zn phthalocyanine complex, anthracene, indene, oxadiazole, oxazole, quadricyclane, diazabicyclooctane, diphenylethylene, triethylamine, triphenylmethane, trimethoxybenzene, naphthalene, norbornadiene, hydrazone, pyrene, phenanthrene, phenothiazine, perylene, and a derivative thereof. The use of such electron donors likely allows the light energy which the porous material collects to be efficiently transferred to the electron donors.

The electron acceptor according to the present invention is not particularly limited, and the electron acceptor suitably used can be at least one kind selected from the group consisting of a quinone compound, an aromatic compound having a vinyl group, an aromatic compound having a cyano group, an aromatic compound having a nitro group, a nitrogen-containing aromatic compound, an organic compound having a dicyanomethylene group, a molecular metal complex containing an organic compound having a dicyanomethylene group as a ligand, an organic compound having a cyanoimino group, a molecular metal complex containing an organic compound having a cyanoimino group as a ligand, fullerene, a carbon nanotube, a metal complex having a nitrogen-containing organic ligand, a metal complex having a cyclic ligand, a metal complex salt, a metal ion, a metal oxide, and a derivative thereof. Among the electron acceptors described above, from the point of view that the electrons are transmitted to the above described electron donor with a higher efficiency, it is preferable to use compounds represented by the following general formula (12): 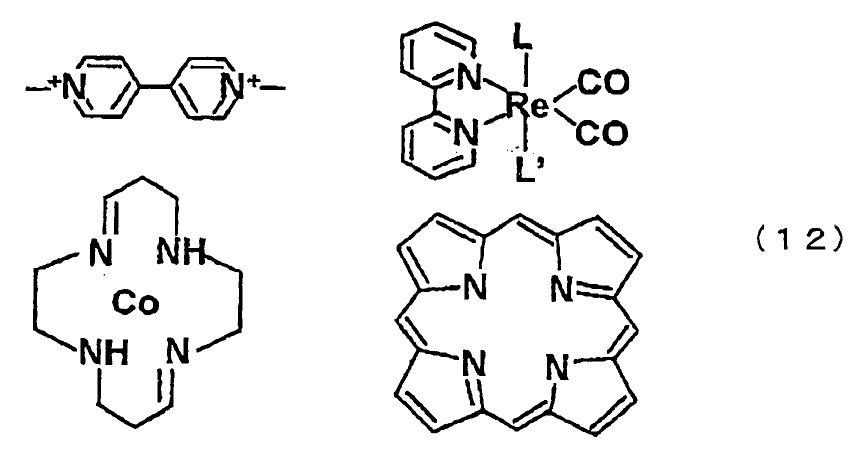 a Cr(bipyridine) complex, Cr(CN)₆³⁻, Fe(CN)₆⁴⁻, Fe³⁺, N, N-dimethylaniline, Pt₂(P₂O₅)₄H₈⁴⁻, methyl cyanobenzoate, dicyanobenzene, dinitrobenzene, benzoquinone, ReCl₈²⁻, Rh₂(1,3-diisocyanopropane)₄²⁻, a Ru(bipyridine) complex, stilbene, UO₂²⁺, a Zn porphyrin complex, Zn phthalocyanine, acetophenone, anthracene, an osmium(II) complex, chloranil, cyanoanthracene, cyanonaphthalene, dimethylaniline, dicyanoanthracene, dicyanonaphthalene, dimethylbicyclohepta-2,5-diene-2,3-dicarboxylate, tetracyanoanthracene, tetracyanoethylene, triphenylpyrylium tetrafluoroborate, naphthalene, nitrobenzene, viologen, phenanthrene, fullerene C60, fullerene C60-µ-oxodimer(C1200), fullerene C70, benzophenone, methylviologen, methoxyacetophenone, oxygen, or a derivative thereof.

Furthermore, as the electron donor and electron acceptor according to the present invention, the compound obtained by binding them may also be used. For example, a compound represented by the following general formula (13) : 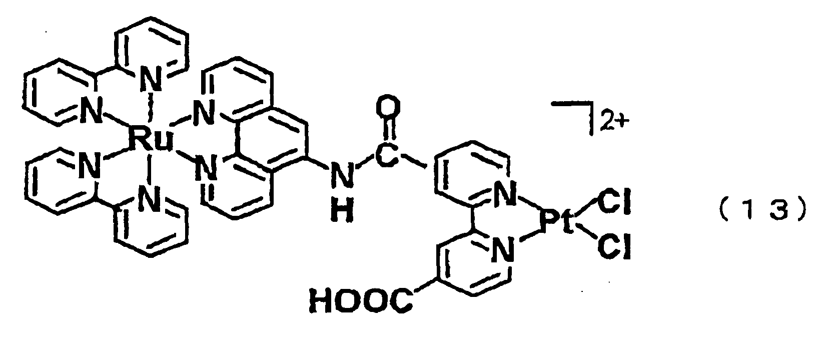 and the like can suitably be used as the electron donor and electron acceptor.

The content of the electron donor is preferably 0.1% by mass to 50% by mass relative to the total amount of the light energy conversion material, more preferably 1.0% by mass to 10% by mass. When the content of the electron donor is less than the lower limit, the light energy which the organic group of the porous material collects tends not to be able to efficiently be utilized. In contrast, when the content of the electron donor exceeds the upper limit, a reaction space for taking the electron acceptor and the reaction substrate in the pore of the porous material tends to significantly be reduced.

The content of the electron acceptor is preferably 0.1% by mass to 50% by mass relative to the total amount of the light energy conversion material, more preferably 1.0% by mass to 10% by mass. When the content of the electron acceptor is less than the lower limit, the efficient transfer of the electrons from the electron donor tends not to be able to be performed. In contrast, when the content of the electron acceptor exceeds the upper limit, the reaction space in the pore of the porous material tends to be significantly reduced.

The content ratio between the electron donor and the electron acceptor is preferably within a range of 1:0.1 to 1:10 in molar ratio, more preferably within a range of 1:1 to 1:2. When the content ratio of the electron acceptor to the electron donor is less than the lower limit, it tends to be difficult to efficiently transfer the electrons from the electron donor to the electron acceptor. In contrast, when the content ratio of the electron acceptor to the electron donor exceeds the above content ratio, the reaction space in the pore of the porous material tends to be significantly reduced.

In the present invention, the electron donor and the electron acceptor are disposed in at least one portion among the pore, the skeleton and the outer circumference of the porous material. Moreover, a photoactive pigment does not needed to be disposed, as the other component, in the pores and the like of the porous material. Accordingly, it is possible to dispose the electron donor and the electron acceptor in proximity to each other at the portion in the pore, the skeleton, and the like, of the porous material. As a result, it is possible to accelerate the occurrence of the electrons and the holes by the charge separation. In addition, the electron donor and the electron acceptor are physically stabilized, resulting in the improvement in the durability of the light conversion material by fixedly disposing the electron donor and the electron acceptor in the pore, the skeleton, and the like, of the porous material. Moreover, in the present invention, it is possible to make the porous material to selectively absorb the light such as ultraviolet light having a strong energy. Therefore, the electron donor and the like are inhibited from being deteriorated due to the light such as ultraviolet light having a strong energy, resulting in the improvement in the durability of the light conversion material.

Furthermore, a method of disposing the electron donor and the electron acceptor in at least one portion among the pore, the skeleton and the outer circumference of the porous material is not particularly limited. A known method, by which the electron donor or the electron acceptor can be disposed in the portion, can suitably be employed. For example, the method can be employed is: a method in which the electron donor and the electron acceptor are fixedly disposed by covalent binding; or a method in which the electron donor and the electron acceptor are fixedly disposed by ion-exchange or by physical exchange. To be specific, the following methods may be employed: a method in which the porous material, the electron acceptor and the like are mixed and heated to covalently bind them to each other, and then in which the electron acceptor and the like are disposed in at least one portion among the pore, the skeleton and the outer circumference of the porous material; a method in which the porous material, the electron acceptor and the like are mixed, irradiated with a ultrasonic wave, and then heated to covalently binding them to each other, and in which the electron acceptor and the like are disposed in at least one portion among the pore, the skeleton and the outer circumference of the porous material; or a method in which a porous material having a thiol group and a sulfonate group in the skeleton is used, in which the porous material is added into the solution containing the electron acceptor and the like, and stirred to fix the electron acceptor and the like to each other by ion binding, and in which the electron acceptor and the like are disposed in at least one portion among the pore, the skeleton and the outer circumference of the porous material. Furthermore, the electron donor or the electron acceptor may be disposed either at the same time or separately in at least one portion among the pore, the skeleton, and the outer circumference of the porous material.

### [Example]

The present invention will more specifically be described below based on examples and comparative example. However, the present invention is not limited to the following examples.

### (Synthesis example 1: synthesis of silica porous material modified by biphenyl group (BiPh-HMM))

First, trimethyloctadecylammonium chloride (surfactant: 1.83g, 5.26mol) was dissolved in the mixture of water (100 ml) and a 6 M aqueous solution of sodium hydroxide (10 g) to obtain a mixed solution. Then, 4,4'-triethoxysilylbiphenyl (2.00 g, 4.18 mol) were added dropwise into the obtained mixed solution while stirring at room temperature. Thereafter, the irradiation with ultrasonic waves for 20 minutes and the stirring were repeated to the mixed solution. Subsequently, the mixed solution was stirred for 24 hours at room temperature to obtain a reaction solution. After that, the reaction solution was left at rest at a temperature condition of 98°C for 48 hours. Then, the reaction solution was heated to obtain a silica porous material modified by a biphenyl group (BiPh-HMM) containing the surfactant. Subsequently, the BiPh-HMM containing the surfactant was suspended in a mixed liquid containing ethanol (260 ml) and concentrated hydrochloric acid (11.7 g) to obtain a suspension solution. Thereafter, the suspension solution was stirred while heating at a temperature condition of 70°C for 7 hours to extract the surfactant from the BiPh-HMM containing the surfactant. After that, the suspension solution was filtered. The obtained white powders were washed with ethanol, and vacuum-dried to obtain BiPh-HMM crystalline powders.

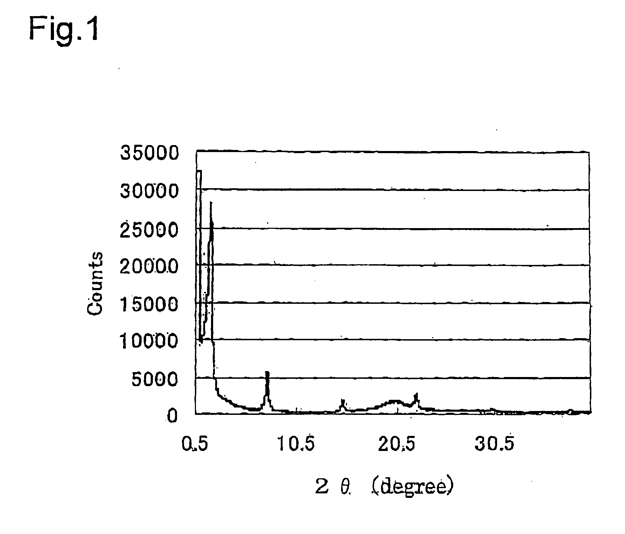

The BiPh-HMM obtained in the above manner was measured by the X-ray diffraction (XRD). The XRD diffraction pattern of the obtained BiPh-HMM is shown in Fig. 1. It was recognized from the result shown in Fig. 1 that a regularly arranged mesoporous structure (d=45. 04 Á) was present in the obtained powdery BiPh-HMM. Furthermore, it was recognized that the periodic structure (d=11.78 Á, 5.90 Á, 3.94 Á, 2.96 Á, 2.37 Á) of the biphenyl groups was present in the pore wall.

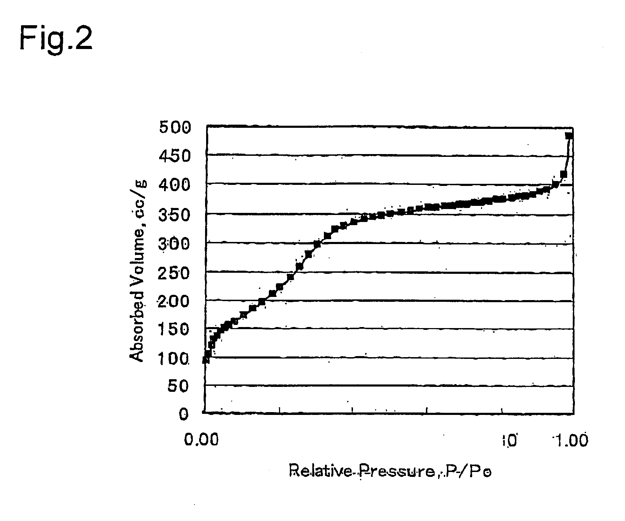

Next, the adsorbed amount of the nitrogen to the obtained BiPh-HMM was measured. Fig. 2 shows the nitrogen adsorption and desorption isotherm of the obtained BiPh-HMM. It was recognized from the result shown in Fig. 2 that the BiPh-HMM showed the typical type IV of the absorption and desorption isotherm in the mesoporous material. Moreover, it was recognized from the calculation based on the adsorption isotherm shown in Fig. 2 that the specific surface area of the pore (BET) was 793.90 m²/g, the pore diameter (BJH) was 23.9 Á, and the volume of the pore was 0.502 cc.

### (Synthesis example 2: synthesis (I) of silica porous material into which bipyridine is introduced (BiPy'-BiPh-HMM))

The BiPh-HMM (1.0 g) obtained in Synthesis example 1, 143 mg of 2,2'-bipyridine derivative having a methoxysilyl group (A-[9-[3-(Trimethoxysilanyl)propyl sulfanyl]butyl]-4-methyl-2,2'-bipyridinyl: hereinafter abbreviated as "BiPy'"), and 20 ml of acetonitrile were mixed in a sample tube. Thereafter, the mixture was irradiated with ultrasonic waves for 1 minute. The mixture was then heated at 70°C for 2 hours to obtain powders. Subsequently, the obtained powders were separated by filtration, washed with ethanol and ion-exchange water, and then dried in vacuum to obtain 977.6 mg of BiPh-HMM powders into which bipyridine was introduced (HiPy'-BiPh-HMM).

### (Synthesis example 3: synthesis of silica porous material (FSM) into which bipyridine was introduced)

1.0 g of FSM, 147 mg of BiPy' and 20 ml of acetonitrile were mixed in a sample tube. Thereafter, the mixture was irradiated with ultrasonic waves for 1 minute. The mixture was then heated at 70°C for 2 hours to obtain powders. Subsequently, the obtained powders were separated by filtration, washed with ethanol and ion-exchange water, and then dried in vacuum to obtain 977.6 mg of FSM powders into which BiPy' was introduced (BiPy'-FSM).

### (Example 1)

50 mg of the BiPy'-BiPh-HMM obtained in Synthesis example 2, 3 mg of a ruthenium complex [Ru(dmb)₂Cl₂·2H₂O (where "dmb" represents 4,4'-dimethyl-2,2'-bipyridine)] and 20 ml of methanol were mixed. Then, the mixture was heated at a temperature condition of 70°C for 15 hours to obtain powders. Thereafter, the obtained powders were separated by filter, washed with methanol, and then dried in vacuum to obtain BiPy'-BiPh-HMM to which the ruthenium complex was fixed (Ru(dmb)₂BiPy'-BiPh-HMM: light energy conversion material).

To measure the amount of the ruthenium complex which was fixed to the Ru (dmb)₂BiPy' -BiPh-HMM thus obtained, the amount of the ruthenium complex which was left in the solution without being fixed to the BiPy'-BiPh-HMM was measured. It was recognized that the amount of ruthenium complex in the solution was hardly reduced, and that the fixed Ru(dmb)₂Cl₂ was 0.1 mg or less.

### (Example 2)

50 mg of the BiPy'-BiPh-HMM obtained in Synthesis example 2, 25 mg of a ruthenium complex (Ru(dmb)₂Cl₂·2H₂O) and 10 ml of methanol were mixed. Then, the mixture was heated at a temperature condition of 70°C for 15 hours to obtain powders. Thereafter, the obtained powders were separated by filtration, washed with methanol, and then dried in vacuum to obtain Ru(dmb)₂BiPy'-BiPh-HMM (light energy conversion material).

To measure the amount of the ruthenium complex which was fixed to the Ru(dmb)₂BiPy'-BiPh-HMM obtained in the above manner, the amount of the ruthenium complex which was left in the solution without being fixed to the BiPy'-BiPh-HMM was measured. As a result, it was recognized that the fixed Ru(dmb)₂Cl₂ was 0.75 mg.

### (Comparative example 1)

50 mg of the BiPy'-FSM, 3 mg of the ruthenium complex (Ru(dmb)₂Cl₂·2H₂O) and 20 ml of methanol were mixed. Then, the mixture was heated at a temperature condition of 70°C for 15 hours to obtain powders. Thereafter, the obtained powders were separated by filtration, washed with methanol, and then dried in vacuum to obtain BiPy'-FSM to which the ruthenium complex was fixed (Ru(dmb)₂BiPy'-FSM: comparative light energy conversion material).

To estimate the amount of the ruthenium complex which was fixed to the Ru(dmb)₂BiPy'-FSM obtained in the above manner, the amount of the ruthenium complex which was left in the solution without being fixed to the BiPy'-FSM was measured. As a result, it was recognized that the fixed Ru(dmb)₂Cl₂ was 0.22 mg.

### [Evaluation of properties of light energy conversion materials obtained in Examples 1 and 2, and Comparative example 1]

### <X-ray diffraction measurement and nitrogen adsorption measurement>

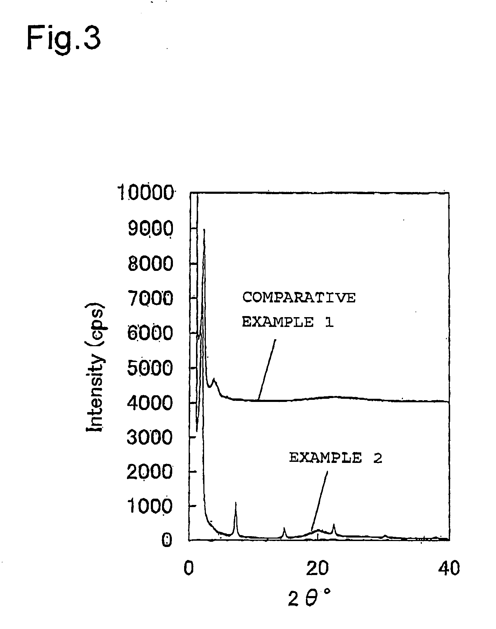

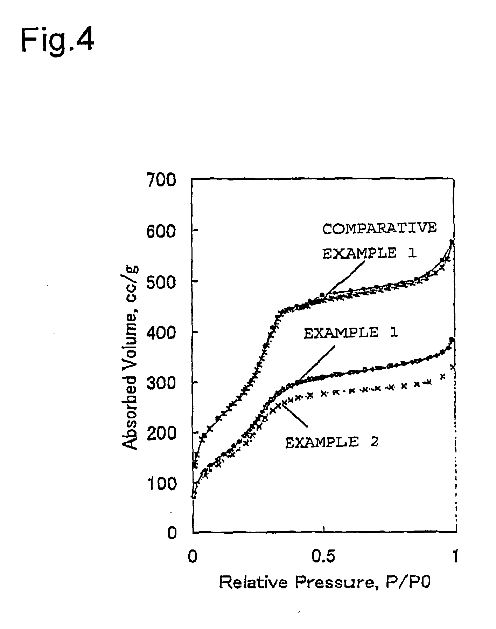

An X-ray diffraction measurement and a nitrogen adsorption measurement were performed using the light energy conversion materials obtained in Example 2 and Comparative example 1 to see that the light energy conversion materials obtained in Example 2 and Comparative example 1 maintained the mesoporous structures. Additionally, a nitrogen adsorption measurement was performed on the light energy conversion material obtained in Example 1 as well. Fig. 3 shows the obtained XRD diffraction patterns. Fig. 4 shows the nitrogen adsorption and desorption isotherms.

As apparent from the results shown in Figs. 3 and 4, it was recognized that the mesostructures of the porous materials were maintained even when the electron donor was disposed in the pore and the skeleton by fixing the BiPy' and subsequently by fixing the ruthenium complex (electron donor) in the light energy conversion materials (Examples 1 and 2 and Comparative example 1).

### <Measurement of UV/Vis spectrum (diffuse reflection spectrum)>

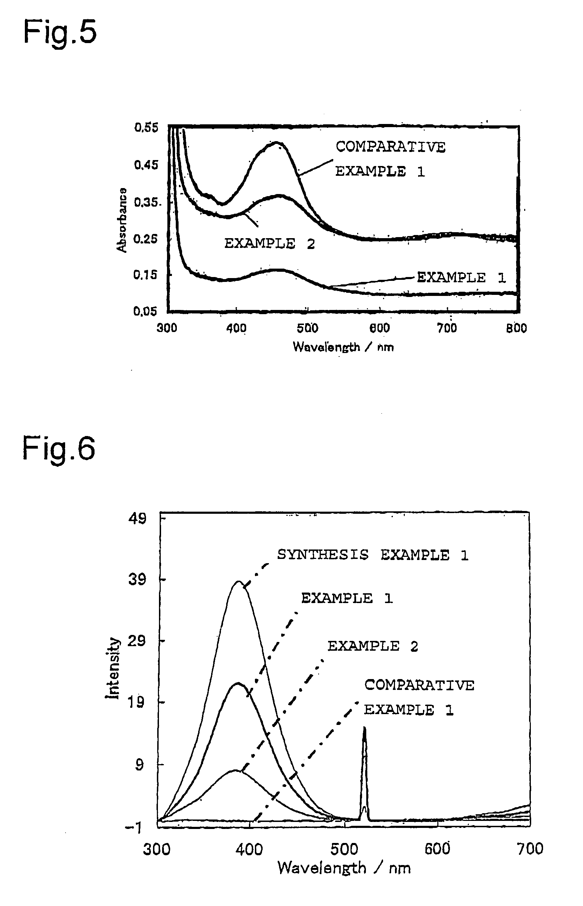

UV/Vis spectra (diffuse reflection spectra) of the light energy conversion materials obtained in Examples 1 and 2 and Comparative example 1 were measured. Fig. 5 shows a graph of the obtained UV/Vis spectra (diffuse reflection spectra).

As apparent from the result shown in Fig. 5, it was recognized that, in the light energy conversion materials obtained in Examples 1 and 2 and Comparative example 1, the MLCT absorption bands each having a form specific to Ru (dmb) ₃²⁺ appeared in a region of 400 nm to 500 nm. From this result, it was recognized that the ruthenium complex was coordinately bound to the BiPy' fixed into the pore and skeleton of the porous material. From this result, it was recognized that the ruthenium complex was fixed by the covalent binding in the pore and skeleton of the porous material.

### <Measurement of luminescence spectrum and excitation spectrum>

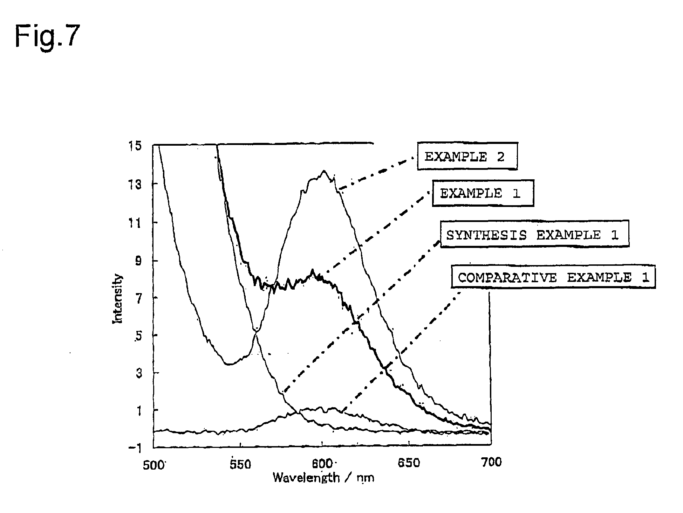

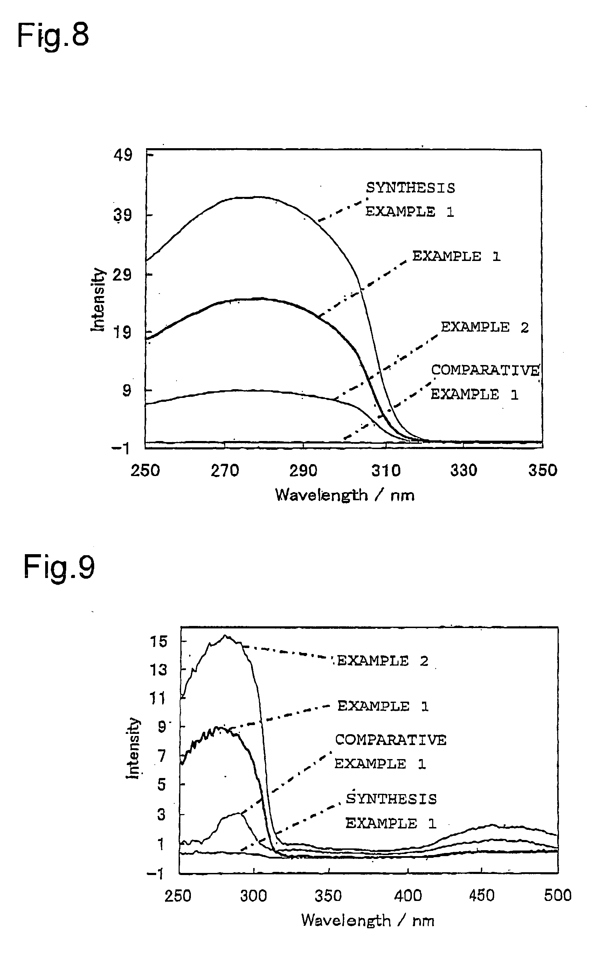

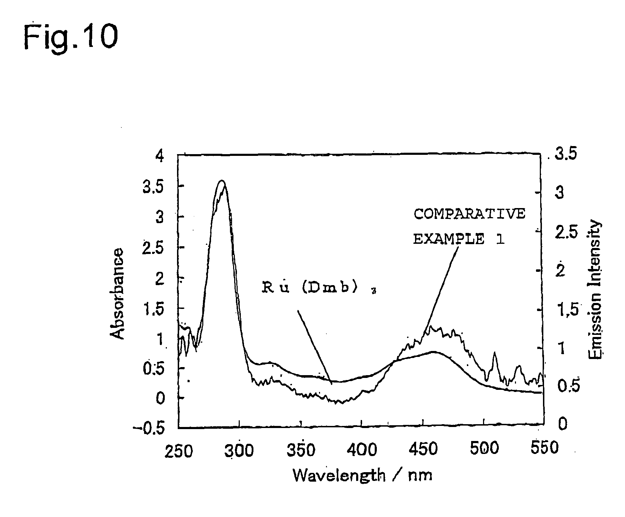

Luminescence spectra and excitation spectra of the BiPh-HMM obtained in Synthesis example 1 and the light energy conversion materials obtained in Examples 1 and 2 and Comparative example 1 were measured. The measurement was performed using a sample prepared by dispersing 0.4 mg of the powders of each light energy conversion material in 4 ml of acetonitrile, by passing an argon gas therethrough for 20 minutes, and then by hermetically sealing the resultant mixture in a container (quarts-made cell). Fig. 6 shows the luminescence spectra of the light energy conversion materials excited with the light having a wavelength of 260 nm. Fig. 7 shows the luminescence spectra of the light energy conversion materials within a wavelength range of 500 nm to 700 nm obtained by performing high sensitivity measurement except for the light having a wavelength of 420 nm or less. In addition, Fig 8 shows the excitation spectra of the light energy conversion materials measured at 380 nm. Fig. 9 shows the excitation spectra of the light energy conversion materials measured at 600 nm. Furthermore, Fig. 10 shows the excitation spectrum of the Ru(dmb)₂BiPy'-FSM (Comparative example 1) obtained when measured at 600 nm, and the UV/Vis spectrum of Ru(dmb)₃(PF₆)₂ in an acetonitrile solution.

As apparent from the results shown in Figs. 6 and 7, the BiPh-HMM (Synthesis example 1) to which ruthenium was not fixed showed the luminescence from the BiPh itself having the maximum in a wavelength region of 380 nm. On the other hand, it was recognized that, in the Ru(dmb)₂BiPy'-BiPh-HMM (Example 1) and the Ru(dmb)₂BiPy'-BiPh-HMM (Example 2) to which the ruthenium complexes were fixed, the strength in the luminescence from the BiPh was reduced, and that the luminescence from the ruthenium complex in a wavelength region of 600 nm was increased. In the Ru (dmb)₂BiPy'-FSM (Comparative example 1) in which the FSM, which does not have BiPh in the skeleton, is used as the porous material, the ruthenium complex disposed in the skeleton was excited when the light having a wavelength of 260 nm was irradiated. The luminescence from the ruthenium complex was however slight.

It was recognized from the results shown in Figs. 8 and 9 that the strength in the excitation spectrum of the Ru(dmb)₂BiPy'-BiPh-HMM (Examples 1 and 2) measured at 380 nm (luminescence band of BiPh) was reduced due to the existence of the ruthenium complex. Moreover, at this time, there was no change in the form of the spectrum. Thus, it was recognized that the light absorption of the BiPh in the skeleton of the porous material was hardly affected when the ruthenium complex was supported. Furthermore, it was recognized that the excitation spectrum of the Ru(dmb)₂BiPy'-BiPh-HMM (Examples 1 and 2) measured at 600 nm (luminescence band of ruthenium complex) showed the form of the BiPh absorption band when the excitation wavelength was 320 nm or less. It was recognized from these results that the light energy which was absorbed by the BiPh in the skeleton of the porous material had been released from the ruthenium complex in the light energy conversion materials (Examples 1 and 2) according to the present invention.

On the other hand, it was recognized from the result shown in Fig. 10 that the excitation spectrum of the Ru (dmb)₂BiPy'-FSM (Comparative example 1) measured at 600 nm was the luminescence which was observed by directly exciting the ruthenium complex, on the basis of the comparison the same with the absorption spectrum of the Ru(dmb)₃²⁺. In addition, it was seen that the strength in the excitation spectrum of the Ru(dmb)₂BiPy'-FSM (Comparative example 1) measured at 600 nm was sufficiently small as compared to those of the Ru(dmb)₂BiPy'-BiPh-HMM (Examples 1 and 2). It was recognized from these results that, in the light energy conversion materials (Examples 1 and 2) according to the present invention, the light was efficiently collected using the BiPh, that the collected light energy was efficiently transferred to the ruthenium complex, and furthermore that the efficient energy transfer was capable to show the strong luminescence (photosensitization effect) compared to the case where the ruthenium complex in the material was directly excited.

### (Synthesis examples 4 and 5)

First, BiPh-HMM having a sulfone group in the skeleton (SO₃H-BiPh-HMM), and BiPh-HMM having a thiol group in the skeleton (SH-BiPh-HMM) were synthesized by employing the same method as the one described in a literature (Inagaki et al. Chem. Lett., 2003, p.914).

100 mg of each obtained SO₃H-BiPh-HMM and SH-BiPh-HMM was added in 2 ml of an acetonitrile solution containing 7 mM of Ru (dmb)₃(PF₆)₂, and then stirred for 1 hour to obtain powders. Subsequently, the powders of each BiPh-HMM obtained in the above manner were separated by filtration, then washed with acetonitrile, and thereafter dried in vacuum to obtain 80.3 mg of the BiPh-HMM to which the ruthenium complex was fixed by ion binding (Ru(dmb)₃SO₃-BiPh-HMM: Synthesis example 4), and 92.3 mg of BiPh-HMM to which the ruthenium complex was fixed by physical adsorption (Ru(dmb)₃SH-BiPh-HMM: Synthesis example 5).

When UV/Vis spectra (diffuse reflection spectra) were measured using the powders of Ru(dmb)₃SO₃-BiPh-HMM (Synthesis example 4) and Ru(dmb)₃SH-BiPh-HMM (Synthesis example 5) obtained in the above manner, the MLCT absorption bands specific to Ru(dmb)₃²⁺ at 400 nm to 500 nm were observed. It was recognized from this result that the ruthenium complex was fixed in the BiPh-HMM.

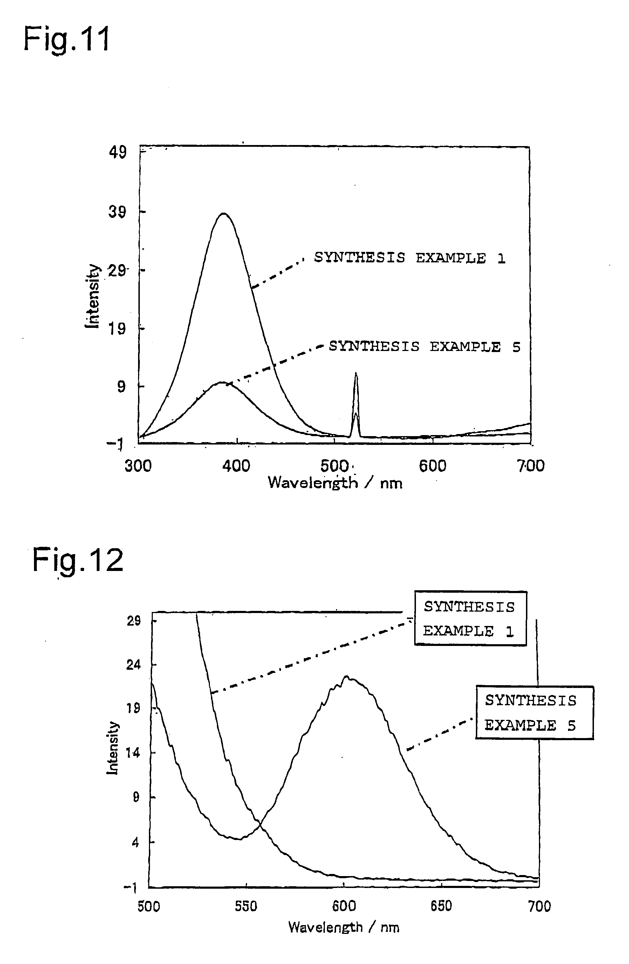

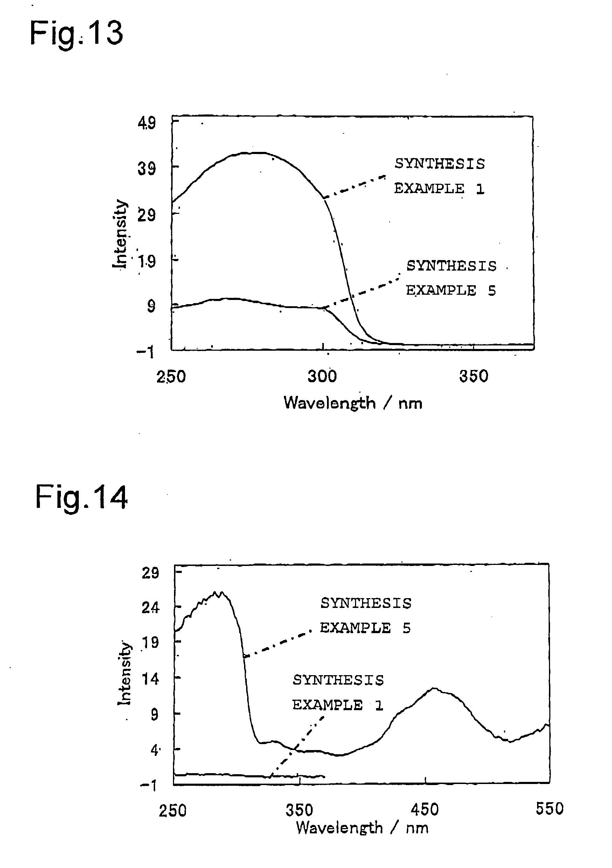

Next, the luminescence spectrum and excitation spectrum of the powders of Ru (dmb)₃SH-BiPh-HMM (Synthesis example 5) obtained in the above manner were measured. The measurement was carried out using a sample prepared by dispersing 0.4 mg of the powders in 4 ml of acetonitrile, by passing an argon gas therethrough for 20 minutes, and then by hermetically sealing the resultant mixture in a container (quarts-made cell). Fig. 11 shows the luminescence spectrum when the Ru(dmb)₃SH-BiPh-HMM (Synthesis example 5) was excited with the light having a wavelength of 260 nm. Fig. 12 shows the luminescence spectrum within a wavelength range of 500 nm to 700 nm obtained by performing measurement with a high sensitivity while removing the light having a wavelength of 420 nm or less. In addition, Fig. 13 shows the excitation spectrum of the Ru(dmb)₃SH-BiPh-HMM (Synthesis example 5) measured at 380 nm. Fig. 14 shows the excitation spectrum measured at 600 nm (the light having a wavelength of 420 nm or less was blocked).

As apparent from the results shown in Figs 11 to 14, it was recognized that the luminescence from the ruthenium complex was observed by exciting the BiPh in the skeleton of the porous material in the Ru(dmb)₃SH-BiPh-HMM (Synthesis example 5). From this result, it was recognized that the light energy collected by the BiPh-HMM was transferred to the ruthenium complex also in the BiPh-HMM composite to which the ruthenium complex was fixed by physical adsorption (Ru(dmb)₃SH-BiPh-HMM (Synthesis example 5)).

### (Example 3)

50 mg of the BiPy'-BiPh-HMM obtained in Synthesis example 2, 14.9 mg of Re(CO)₅Cl and 10 ml of toluene were mixed. Then, an argon gas was passed therethrough for 20 minutes. Thereafter, the mixture was heated under reflux for 5 hours to obtain powders. The obtained powders were separated by filtration, washed with toluene and acetone, ethanol, acetone, and diethyl ether in this order, and then dried in vacuum to obtain 50.4 mg of BiPh-HMM to which a rhenium complex was fixed (ReCl(CO)₃BiPy'-BiPh-HMM: Example 3).

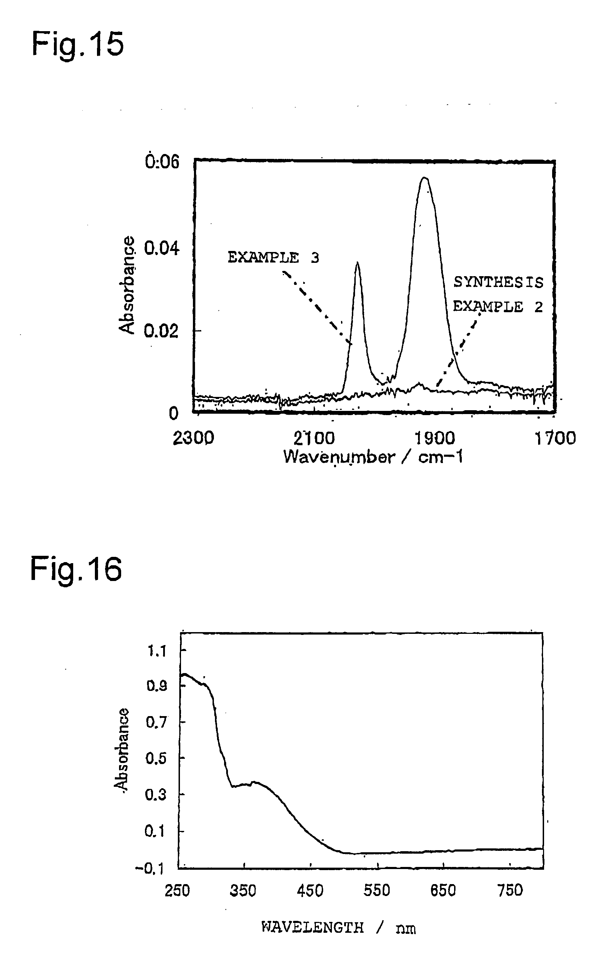

An IR spectrum of the ReCl (CO)₃BiPy' -BiPh-HMM (light energy conversion material) obtained in the above manner was measured. Fig. 15 shows the obtained IR spectrum of the ReCl(CO)₃BiPy'-BiPh-HMM.

Next, a UV/Vis spectrum (diffuse reflection spectrum) of the ReCl(CO)₃BiPy'-BiPh-HMM obtained in the above manner was measured. Fig. 16 shows the obtained UV/Vis spectrum.

As apparent from the result shown in Fig. 15, the ν (CO) absorption band appeared in the fac-Re(CO)₃ pattern within 2200 cm⁻¹ to 1800 cm⁻¹. Thus, it was recognized that that two molecules of CO were separated from Re(CO)₅Cl in the raw material, and instead the BiPy' in the BiPy'-BiPh-HMM is coordinated in the rhenium center. In addition, as apparent from the result shown in Fig. 16, the MLCT absorption band specific to Re(dmb) (CO)₃Cl was recognized within a range of 320 nm to 400 nm.

Then, the luminescence spectrum and the excitation spectrum of the ReCl(CO)₃BiPy'-BiPh-HMM (Example 3) obtained in the above manner were measured. The measurement was carried out using a sample prepared by dispersing 0.4 mg of the powders of the obtained ReCl(CO)₃BiPy'-BiPh-HMM (Example 3) in 4 ml of acetonitrile, by passing an argon gas therethrough for 20 minutes, and then by hermetically sealing the resultant mixture in a container (quarts-made cell). Fig. 17 shows: the luminescence spectrum obtained when the ReCl(CO)₃BiPy'-BiPh-HMM (Example 3) was excited with the light having a wavelength of 260 nm; the luminescence spectrum obtained by performing high sensitivity measurement while removing the light having a wavelength of 420 nm or less when the ReCl(CO)₃BiPy'-BiPh-HMM is excited with the light having a wavelength of 260 nm; and the luminescence spectrum obtained by performing high sensitivity measurement while removing the light having a wavelength of 420 nm or less when the ReCl(CO)₃BiPy'-BiPh-HMM is excited with the light having a wavelength of 350 nm. In addition, Fig. 18 shows the excitation spectrum of the ReCl(CO)₃BiPy'-BiPh-HMM (Example 3) measured at 550 nm.

As apparent from the result shown in Fig. 17, it was recognized, in the luminescence spectrum obtained, that when the BiPh was excited with the light having a wavelength of 260 nm, the luminescence from the BiPh (λₘₐₓ=380 nm) was significantly quenched, and that the luminescence of the Re(dmb)(CO)₃Cl having the maximum at 550 nm appeared. On the other hand, it was recognized that the luminescence from the rhenium complex was increased when the BiPh was excited with the light having a wavelength of 260 nm as compared to the case where the rhenium complex was directly excited by irradiating the ReCl(CO)₃BiPy'-BiPh-HMM (Example 3) with the light having a wavelength of 350 nm. From this result, it was recognized, in the light energy conversion material of the present invention, that the light energy collected by the organic group (BiPh) was transferred to the rhenium complex, and that the rhenium complex showed the strong luminescence compared to the case where when the rhenium complex was directly excited (photosensitization effect) .

Furthermore, as apparent from the result shown in Fig. 18, when the luminescence intensity from the rhenium complex at 550 nm was monitored, the ReCl (CO)₃BiPy'-BiPh-HMM (Example 3) showed the form of the BiPh absorption band in an excitation wavelength region of 320 nm or less. Thus, it was recognized that the light energy absorbed by the BiPh in the mesoporous skeleton was released from the rhenium complex in the Red(CO)₃BiPy'-BiPh-HMM (Example 3).

### (Example 4)

The BiPh-HMM to which both the rhenium complex and the ruthenium complex were fixed was obtained by fixing BiPy' to the powders of the BiPh-HMM obtained in Synthesis example 4 to which the ruthenium complex was fixed, and by further fixing the rhenium complex to the BiPy'. Specifically, at first, 50 mg of Ru(dmb)₃SO₃-BiPh-HMM, 52.2 mg of BiPy', and 4 ml of acetonitrile were mixed in a sample tube. Then, the mixture was irradiated with ultrasonic waves for 1 minute, and heated at 70°C for 2 hours to obtain powders. The obtained powders were separated, washed, and then dried in vacuum. Subsequently, 36. 4 mg of the powders, 44.5 mg of Re(CO)₅Cl and 10 ml of toluene were mixed. An argon gas was passed through the mixture for 20 minutes. The mixture was then heated under reflux for 5 hours to obtain second powders. Thereafter, the second powders were separated by filtration, washed with toluene and acetone, ethanol, acetone, and diethyl ether in this order, and then dried in vacuum to obtain the BiPh-HMM (light energy conversion material) to which both the rhenium complex and the ruthenium complex were fixed.

### (Example 5)

BiPh-HMM (light energy conversion material) to which both the rhenium complex and the ruthenium complex were fixed was obtained in the same manner as in Example 4 except that the BiPh-HMM obtained in Synthesis example 5 to which the ruthenium complex was fixed (Ru(dmb)₃SH-BiPh-HMM) was used instead of the BiPh-HMM obtained in Synthesis example 4 to which the ruthenium complex was fixed.

### (Example 6)

BiPh-HMM (light energy conversion material) to which both the rhenium complex and the ruthenium complex were fixed was obtained in the same manner as in Example 4 except that Ru (bpy)SO₃-BiPh-HMM was used instead of the BiPh-HMM obtained in Synthesis example 4 to which the ruthenium complex was fixed. Incidentally, the Ru (bpy)SO₃-BiPh-HMM was produced by using Ru(bpy)₃(PF₆)₂ instead of the Ru(dmb)₃(PF₆)₂ and employing the same method as in Synthesis example 4.

### (Example 7)

BiPh-HMM (light energy conversion material) to which both the rhenium complex and the ruthenium complex were fixed was obtained in the same manner as in Example 4 except that Ru(bpy)SH-BiPh-HMM was used instead of the BiPh-HMM obtained in Synthesis example 4 to which the ruthenium complex was fixed. Incidentally, the Ru(bpy)SH-BiPh-HMM was produced by using the Ru(bpy)₃(PF₆)₂ instead of the Ru(dmb)₃(PF₆)₂ and employing the same method as in Synthesis example 5.

### [Evaluation of properties of light energy conversion materials obtained in Examples 4 to 7]

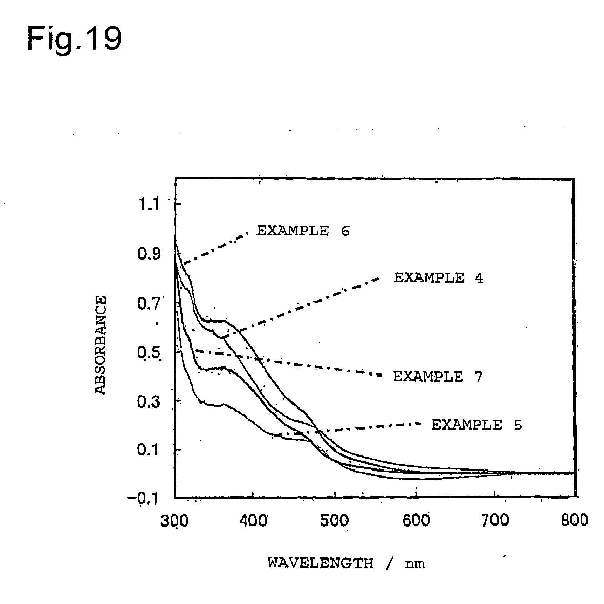

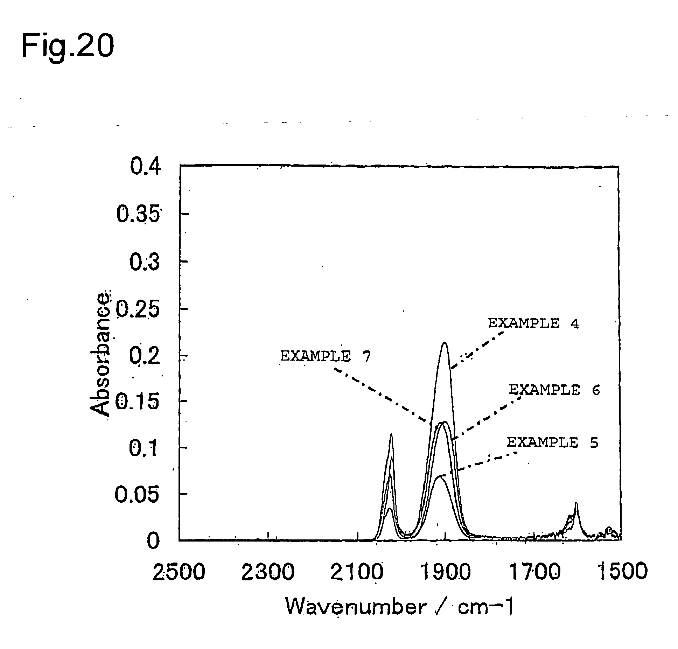

Fig. 19 shows the UV/Vis spectra (diffuse reflection spectra) of the BiPh-HMMs obtained in Examples 4 to 7 which both the rhenium complex and the ruthenium complex were fixed to. Fig. 20 shows the IR spectra of the BiPh-HMMs obtained in Examples 4 to 7 which both the rhenium complex and the ruthenium complex were fixed to.

As apparent from the UV/Vis spectra shown in Fig. 19, in the products obtained in Examples 4 to 7, the MLCT absorptions of the ruthenium complex and the rhenium complex were recognized within wavelength ranges of 400 nm to 500 nm, and 320 nm to 400 nm, respectively. It was recognized from this result that the ruthenium complex and the rhenium complex were fixed to the BiPh-HMM in the products obtained in Example 4 to 7. As apparent from the IR spectra shown in Fig. 20, the ν (CO) was measured in the pattern from the fac-Re(CO)₃ structure of the rhenium complex. Thus, it was recognized that the BiPy' was fixed so as to be coordinated in the rhenium center.

### <CO₂ photoreduction reaction>

Each BiPh-HMM (light energy conversion material) obtained in Examples 4 to 7 which both the rhenium complex and the ruthenium complex were fixed to was mixed in an acetonitrile solution containing triethanolamine (triethanolamine: acetonitrile=1:5 (by volume)). Then, the mixture was irradiated with the light having a wavelength of 280 nm in an atmosphere of carbon dioxide to reduce the carbon dioxide. A closed-circulatory photocatalytic evaluator was used for the reduction reaction of the carbon dioxide. Carbon monoxide (the reduction product of carbon dioxide) contained in the circulation gas was analyzed with a gas chromatography.

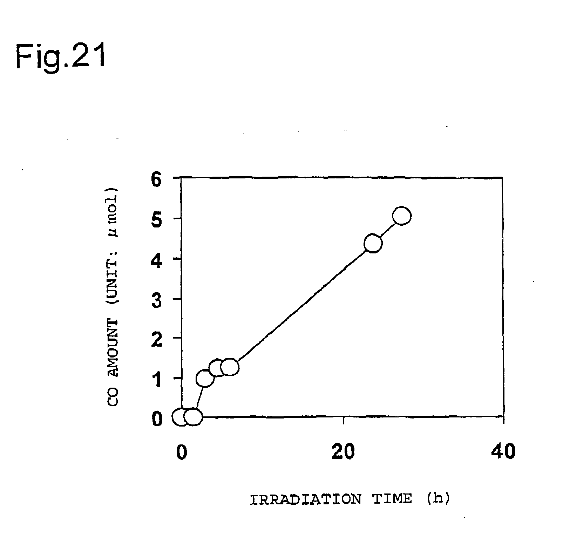

It was recognized from the result of such an analysis that the carbon dioxide was reduced to form carbon monoxide by using the light energy conversion materials obtained in Examples 4 to 7. As a result, it was found that the light energy conversion materials (Examples 4 to 7) of the present invention were useful as photocatalysts. Fig. 21 is a graph showing the relationship between the generated amount of carbon monoxide and the light irradiation time for the BiPh-HMM obtained in Example 4 which both the rhenium complex and the ruthenium complex are fixed to.

### (Synthesis example 6 : synthesis (II) of silica porous material into which bipyridine is introduced (BiPy'-BiPh-HMM))

First, the silica porous material modified by a biphenyl group containing a surfactant (BiPh-HMM containing a surfactant) was obtained by employing the same method as that employed in Synthesis example 1. Then, the BiPh-HMM containing the surfactant (900 mg), the BiPy' (141 mg), and acetonitrile (10 ml) were mixed in a sample tube. Subsequently, the mixture was irradiated with ultrasonic waves for 1 minute, and thereafter heated at 70°C for 2 hours to obtain powders. After that, the obtained powders were suspended in a mixed solution containing ethanol (180 ml) and concentrated hydrochloric acid (8 g) to obtain a first suspension liquid. Then, the first suspension liquid was heated at a temperature condition of 75°C overnight to extract the surfactant from the powders. Thereafter, the powders were separated from the first suspension liquid by filtration to obtain BiPh-HMM powders in which bipyridine was introduced in the protonated state.

Next, 1 g of the BiPh-HMM powders obtained in the above manner in which bipyridine was introduced in the protonated state was suspended in 20 ml of an acetonitrile mixed solution containing 0. 5 M of triethylamine to obtain a second suspension liquid. Thereafter, the second suspension liquid was stirred at normal temperature (25°C) overnight to neutralize the protonated bipyridine. Subsequently, the second suspension liquid was filtered to separate powders therefrom. The obtained powders were dried in vacuum to obtain a silica porous material in which bipyridine was introduced (BiPy'-BiPh-HMM). Incidentally, it was recognized from the result of the element analysis for the S atom that the content ratio of the bipyridine which was introduced in the obtained BiPy'-BiPh-HMM was 0.25 mmol/g.

### (Synthesis examples 7 to 9: synthesis (III) of silica porous materials in which bipyridine is introduced (BiPy'-BiPh-HMMs))

First, 6.7 g of a surfactant (trimethyloctadecylammmonium chloride) was dissolved in a mixed liquid of water (240 ml) and a 6M aqueous solution of sodium hydroxide (18 ml) to obtain first mixture solutions. Then, mixed liquids (the mixing ratio of BiPy' was 10 mol% in Synthesis example 7; the mixing ratio of BiPy' was 30 mol% in Synthesis example 8; the mixing ratio of BiPy' was 50 mol% in Synthesis example 9) containing 4,4'-triethoxysilylbiphenyl and BiPy' both of which are 16.8 mmol in the total amount were added dropwise to the first mixture solutions while stirring at room temperature (25°C) to obtain second mixture solutions. Subsequently, the irradiation with ultrasonic waves for 3 minutes and the stirring for 10 seconds were repeated 10 times to the obtained second mixture solutions. Thereafter, the mixture solutions were stirred at room temperature (25°C) for 18 hours to obtain reaction solutions. Then, the obtained reaction solutions were heated at a temperature condition of 95°C for 20 hours to obtain silica porous materials containing surfactants (BiPh-HMMs containing surfactants). After that, the BiPh-HMMs containing the surfactants (1 g) were suspended in a mixed liquid containing ethanol (200 ml) and concentrated hydrochloric acid (9 g) to obtain first suspension liquids. Subsequently, the first suspension liquids were heated at a temperature condition of 75°C overnight to extract the surfactants from the BiPh-HMMs containing the surfactants. Thereafter, the first suspension liquids were filtered to separate powders therefrom. As a result, BiPh-HMM powders, in which bipyridine was introduced in the protonated state, were obtained.

Next, 1 g of the BiPh-HMM powders in which the bipyridine was introduced in the protonated state were suspended in 20 ml of a mixed ethanol solution containing 0. 5 M of triethylamine to obtain second suspension liquids. The obtained second suspension liquids were stirred at normal temperature (25°C) overnight to neutralize the protonated bipyridine. Thereafter, the second suspension liquids were filtered to separate powders therefrom. The obtained powders were dried in vacuum to obtain silica porous material powders in which bipyridine was introduced (BiPy'-BiPh-HMMs). Incidentally, it was recognized that the content ratio of the bipyridine introduced in BiPy'-BiPh-HMMs obtained in Synthesis examples 7 to 9 depended on the mixing ratio of the BiPy' in the aforementioned mixed liquid containing 4,4'-triethoxysilylbiphenyl and BiPy'. Moreover, it was recognized from the result of the element analysis of the S atom that the content ratios of the bipyridine were 0.16 mmol/g (Synthesis example 7), 0.47 mmol/g (Synthesis example 8) and 0.78 mmol/g (Synthesis example 9).

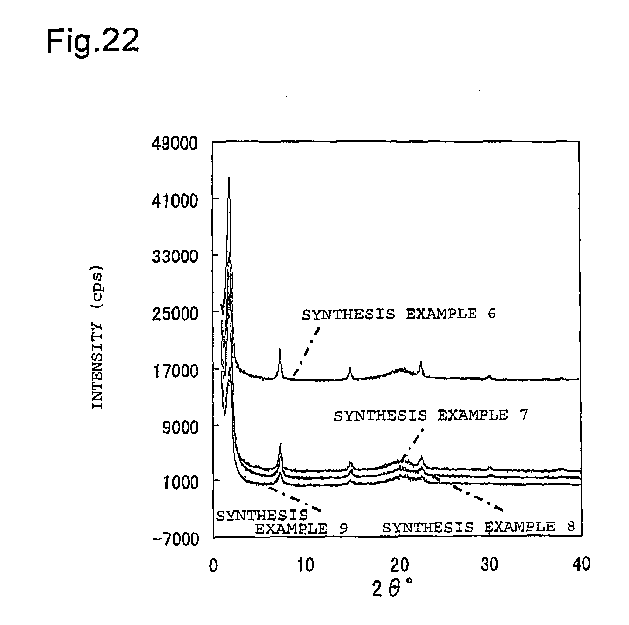

The BiPy'-BiPh-HMMs obtained in Synthesis examples 6 to 9 were measured by the X-ray diffraction (XRD). Fig. 22 shows the XRD patterns of the BiPy'-BiPh-HMMs obtained in Synthesis examples 6 to 9. It was recognized from the result shown in Fig. 22 that a regularly arranged mesopore structure (d=45.04 Á) was present in each powdery BiPy'-BiPh-HMM obtained in Synthesis examples 6 to 9. In addition, it was recognized that the periodic structure (d=11.78 Á, 5.90 Á, 3.94 Á, 2.96 Á, 2.37 Á) of the biphenyl groups was present in the pore wall.

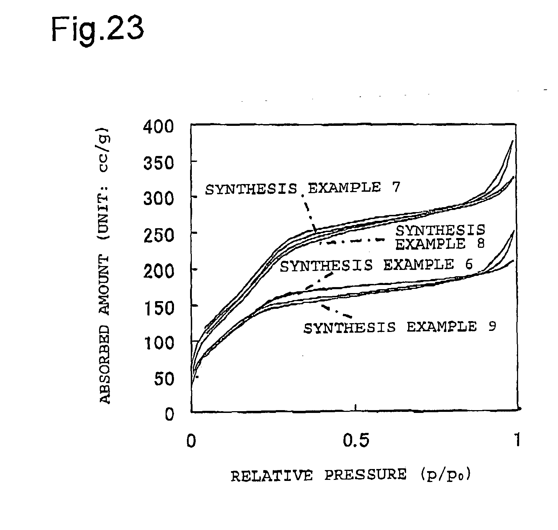

Next, the adsorbed amounts of the nitrogen to the BiPy'-BiPh-HMMs obtained in Synthesis examples 6 to 9 were measured. Fig. 23 shows the nitrogen adsorption isotherms of the BiPy'-BiPh-HMMs obtained in Synthesis examples 6 to 9. It was recognized from the result shown in Fig. 23 that each BiPy'-BiPh-HMM obtained in Synthesis examples 6 to 9 showed the typical type IV of the adsorption and desorption isotherm in the mesoporous material. Moreover, it was recognized from the calculation based on the adsorption isotherm shown in Fig. 23 that: the specific surface areas of the pores (BET) of the BiPy'-BiPh-HMMs obtained in Synthesis examples 6 to 9 were 619.8 m²/g (Synthesis example 6), 769.7 m²/g (Synthesis example 7), 767.0 m²/g (Synthesis example 8) and 571.3 m²/g (Synthesis example 9) ; the pore diameters (BJH) were 2.1 Á (Synthesis example 6), 2.1 Á (Synthesis example 7), 2.1 Á (Synthesis example 8) and 1.8 Á (Synthesis example 9); and the pore volumes were 0.24 cc (Synthesis example 6), 0.24 cc (Synthesis example 7), 0.23 cc (Synthesis example 8) and 0.14 cc (Synthesis example 9).

### (Examples 8 to 10)

By employing Ru(dmb)₂Cl₂ to each BiPy'-BiPh-HMM obtained in Synthesis examples 7 to 9, the ruthenium complexes were fixed in ratios of: 0.040 mmol/g relative to the porous material obtained in Synthesis example 7 (Example 8); 0.037 mmol/g relative to the porous material obtained in Synthesis example 8 (Example 9); and 0.052 mmol/g relative to the porous material obtained in Synthesis example 9 (Example 10), to obtain Ru(dmb)₂BiPy'-BiPh-HMMs (light energy conversion materials). Incidentally, as a method of fixing the ruthenium complex using the Ru(dmb)₂Cl₂, the method as that employed in Example 1 was employed.

### [Evaluation of properties of light energy conversion materials obtained in Examples 8 to 10]

### <Measurement of luminescence quantum yield>

The luminescence quantum yields of the Ru(dmb)₂BiPy'-BiPh-HMMs (light energy conversion materials) obtained in Examples 8 to 10 were measured. Such measurement was carried out using a sample prepared by dispersing 1 mg of each of the light energy conversion material powders in 4 ml of acetonitrile, by passing an argon gas therethrough for 20 minutes, and then by hermetically sealing the resultant mixture in a container (quarts-made cell).

As the result of such measurement, the luminescence quantum yield of each light energy conversion material excited with the light having a wavelength of 2.65 nm was 0.10 to 0.11 in any case. Only the luminescence from the ruthenium complex was observed. On the other hand, the luminescence quantum yield of each light energy conversion material excited with the light having a wavelength of 450 nm was 0.10 to 0.12 in any case. Only the luminescence from the ruthenium complex was observed. It was seen from the result that, when the BiPh in the skeleton of the porous material was excited with the light having a wavelength of 265 nm, the energy transfer occurred in the ruthenium complex with an efficiency of almost 100%, and the luminescence from the ruthenium complex was observed. It was also recognized that the light energy absorbed by the BiPh in the skeleton of the porous material was released from the ruthenium complex in the light energy conversion materials (Examples 8 to 10) of the present invention.

### (Examples 11 to 13)

Re(CO)₅Cl was fixed to each of the BiPy'-BiPh-HMMs obtained in Synthesis examples 7 to 9 by the same method as that employed in Example 3, and thereby ReCl(CO)₃BiPy'-BiPh-HMMs (light energy conversion materials) were obtained.

### [Evaluation of properties of light energy conversion materials obtained in Examples 11 to 13]

### <Measurement of luminescence quantum yield>

The luminescence quantum yields of the ReCl(CO)₃BiPy'-BiPh-HMMs (light energy conversion materials) obtained in Examples 11 to 13 were measured. Such measurement was carried out using a sample prepared by dispersing 1 mg of each of the light energy conversion material powders in 4 ml of acetonitrile, by passing an argon gas therethrough for 20 minutes, and then by hermitically sealing the resultant mixture in a container (quarts-made cell).

As the result of such measurement, the luminescence quantum yields of the ReCl(CO)₃BiPy'-BiPh-HMMs excited with the light having a wavelength of 265 nm were 0.02 to 0.03 in any case. Only the luminescence from the rhenium complex was observed. On the other hand, the luminescence quantum yields of the ReCl(CO)₃BiPy'-BiPh-HMMs excited with the light having a wavelength of 350 nm was 0.02 to 0.03 in any case. Only the luminescence from the rhenium complex was observed. It was seen from the result that, when the BiPh in the skeleton of the porous material was excited with the light having a wavelength of 265 nm, the energy transfer occurred in the rhenium complex with an efficiency of almost 100%, and the luminescence from the rhenium complex was observed. It was also recognized that the light energy absorbed by the BiPh in the skeleton of the porous material was released from the rhenium complex in the light energy conversion materials (Examples 11 to 13) of the present invention.

### (Example 14)

Using the BiPy'-BiPh-HMM obtained in Synthesis example 8, Re(PPh₃) (CO)₃BiPy'-BiPh-HMM (light energy conversion material) was obtained by employing the same method as that employed in Example 3 except that 17.3 mg of Re (CO)₅(PPh₃) (CF₃SO₃) was used instead of the Re(CO)₅Cl.

### (Example 15)

Re(PPh₃) (CO)₃BiPy'-BiPh-HMM (light energy conversion material) was obtained by employing the same method as that employed in Example 14 except that the BiPy'-BiPh-HMM obtained in Synthesis example 9 and 28.9 mg of Re(CO)₅(PPh₃) (CF₃SO₃) was used.

### [Evaluation of properties of light energy conversion materials obtained in Examples 14 to 15]

### <Measurement of luminescence quantum yield>

The luminescence quantum yields of the Re(PPh₃)(CO)₃BiPy'-BiPh-HMMs (light energy conversion materials) obtained in Examples 14 to 15 were measured. Such measurement was carried out using a sample prepared by dispersing 1 mg of each of the light energy conversion material powders in 4 ml of acetonitrile, by passing an argon gas therethrough for 20 minutes, and then by hermetically sealing the resultant mixture in a container (quarts-made cell).

As the result of such measurement, the luminescence quantum yields of the Re(PPh₃) (CO)₃BiPy'-BiPh-HMMs excited with the light having a wavelength of 265 nm were 0.03 in any case. Only the luminescence from the rhenium complex was observed. On the other hand, the luminescence quantum yields of the Re(PPh₃) (CO)₃BiPy'-BiPh-HMMs excited with the light having a wavelength of 350 nm was 0.05 in any case. Only the luminescence from the rhenium complex was observed. It was seen from the result that, when the BiPh in the skeleton of the porous material was excited with the light having a wavelength of 265 nm, the energy transfer occurred in the rhenium complex, and the luminescence from the rhenium complex was observed. The efficiency of transferring energy to the rhenium complex does not reach 100% when the BiPh in the skeleton of the porous material is excited with the light having a wavelength of 265 nm even though the luminescence from the BiPh is completely quenched. This suggests that the part of the BiPh in the skeleton of the porous material, which is excited with the light having a wavelength of 265 nm supplies electrons to the portion of the Re(PPh3) having a strong electron-accepting property. Therefore, it was recognized that the light energy absorbed by the BiPh in the skeleton of the porous material was released from the rhenium complex in the light energy conversion materials (Examples 14 to 15) of the present invention. Furthermore, it was suggested that the BiPh excited with light supplied electrons to the rhenium complex.

### [Evaluation of properties of light energy conversion materials obtained in Examples 3 and 14]

### <CO₂ photoreduction reaction>

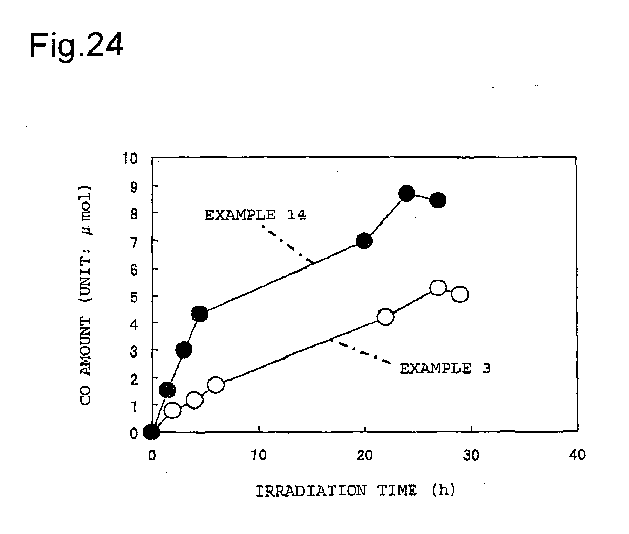

Each of the ReCl(CO)₃BiPy'-BiPh-HMM (light energy conversion material) obtained in Example 3 and the Re(PPh₃)(CO)₃BiPy'-BiPh-HMM (light energy conversion material) obtained in Example 14 was mixed in an acetonitrile solution containing triethanolamine (triethanolamine:acetonitrile=1:5 (by volume)). Thereafter, each light energy conversion material was irradiated with the light having a wavelength of 280 nm in the atmosphere of carbon dioxide to reduce carbon dioxide. A closed-circulatory photocatalytic evaluator was used for the reduction reaction of the carbon dioxide. Carbon monoxide (the reduction product of carbon dioxide) contained in the circulation gas was analyzed with a gas chromatography. Fig. 24 is a graph showing the relationship between the generated amount of carbon monoxide and the light irradiation time for the light energy conversion materials obtained in Examples 3 and 14.

It was recognized from the result shown in Fig. 24 that the carbon dioxide was reduced to form carbon monoxide by using the light energy conversion materials (Examples 3 and 14) of the present invention. As a result, it was seen that the light energy conversion material of the present invention was useful as a photocatalyst. It was recognized that, with respect to the light energy conversion material (PeCl(CO)₃BiPy'-BiPh-HMM) obtained in Example 3, the BiPh-HMM skeleton played a role as a light energy collector and a light energy donor, the portion of the Re (metal ion) played a role as a light energy acceptor and an electron donor, and furthermore a BiPy' ligand (nitrogen-containing aromatic compound) played a role as an electron acceptor, and thereby the CO₂ reduction reaction was progressed. On the other hand, it was recognized that, with respect to the light energy conversion material (Re(PPh₃) (CO)₃BiPy'-BiPh-HMM) obtained in Example 14, the BiPh-HMM skeleton played a role as a light energy collector and a light energy donor, the portion of Re (metal ion) played a role as a light energy acceptor and an electron donor, and furthermore a BiPy' ligand (nitrogen-containing aromatic compound) played a role as an electron acceptor, and thereby the CO₂ reduction reaction was progressed.

### [Industrial Applicability]

As described above, according to the present invention, it is possible to provide a light energy conversion material which can advance a light energy conversion reaction with a high efficiency, resulting in the significant improvement in the light energy conversion efficiency, and, further, which can improve the physical stabilities of an electron donor and an electron acceptor to give the light conversion material a sufficient durability. Therefore, the light energy conversion material according to the present invention provides an excellent light energy conversion efficiency, and thus is suitably utilized for the fields of a photocatalyst such as the photoreduction catalyst for CO₂ and H₂O and a solar battery.

It is explicitly stated that all features disclosed in the description and/or the claims are intended to be disclosed separately and independently from each other for the purpose of original disclosure as well as for the purpose of restricting the claimed invention independent of the compositions of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A light energy conversion material, comprising:
a porous material having a light-collecting antenna function; and
an electron donor and an electron acceptor disposed in at least one portion among a pore, a skeleton and the outer circumference of the porous material.

2. The light energy conversion material according to claim 1, wherein the porous material is a silica porous material containing an organic group.

3. The light energy conversion material according to claim 2, wherein the organic group includes an organic molecule having an absorption band between 200 nm and 800 nm.

4. The light energy conversion material according to claim 2, wherein the porous material has a periodic structure with an interval of 5 nm or less based on the regular arrangement of the organic groups.

5. The light energy conversion material according to any one of claims 1 to 4, wherein the porous material has pores with a central pore diameter of 1 nm to 30 nm.

6. The light energy conversion material according to any one of claims 1 to 5, wherein the porous material has one or more peaks at a diffraction angle corresponding to a d value of 1 nm or more in an X-ray diffraction pattern.

7. The light energy conversion material according to any one of claims 1 to 6, wherein the electron donor is at least one kind selected from the group consisting of an aromatic compound, a peri-condensed aromatic compound, a polycyclic aromatic compound, a nitrogen-containing aromatic compound, a sulfur-containing aromatic compound, an aromatic vinyl polymer, an aromatic amine compound, an alkyl amine compound, a nitro compound, a metal complex having a nitrogen-containing organic ligand, a metal complex having a cyclic ligand, a metal complex salt, a metal ion, a rare-earth ion, a halogen ion, and a derivative thereof.

8. The light energy conversion material according to any one of claims 1 to 7, wherein the electron acceptor is at least one kind selected from the group consisting of a quinone compound, an aromatic compound having a vinyl group, an aromatic compound having a cyano group, an aromatic compound having a nitro group, a nitrogen-containing aromatic compound, an organic compound having a dicyanomethylene group, a molecular metal complex containing an organic compound having a dicyanomethylene group as a ligand, an organic compound having a cyanoimino group, a molecular metal complex containing an organic compound having a cyanoimino group as a ligand, fullerene, a carbon nanotube, a metal complex having a nitrogen-containing organic ligand, a metal complex having a cyclic ligand, a metal complex salt, a metal ion, a metal oxide, and a derivative thereof.
